# EUROPEAN PATENT APPLICATION

(11) **EP 1 956 615 A2**
(43) Date of publication of application: **13.08.2008**
(21) Application number: 07254736.7
(22) Date of filing: 07.12.2007
(51) Int. Cl.: H01F 17/00, H05K 1/02, H05K 1/16, H04B 1/38, H01L 23/48, H01L 23/52, H01L 23/64

(54) **Electronic device and RF module**

(30) Priority: 08.12.2006 JP 2006331358; 01.02.2007 JP 2007022606; 14.11.2007 JP 2007295938
(71) Applicant: Renesas Technology Corp., Tokyo 100-0004 (JP)
(72) Inventor: Takahashi, Wataru, Tokyo 100-0004 (JP); Tsuchida, Shigeru, Tokyo 100-0004 (JP); Okabe, Hiroshi, Tokyo 100-8220 (JP)
(74) Representative: Calderbank, Thomas Roger

(57) **Abstract**

A parallel resonant circuit is realized by stacking first to fourth wiring patterns each having at least an inductance element. One of the adjacent first and second wiring patterns is set to a signal input node and the other thereof is set to a signal output node. Then, the signal input node is connected to the signal output node via inductance elements of the first wiring pattern, third wiring pattern, fourth wiring pattern and second wiring pattern in order. By adjacently forming wiring layers of the signal input and output nodes, a capacitance value between the input and output nodes is increased compared to that when they are separated. Also, by increasing the line width of the first and second wiring patterns, the capacitance value can be further increased. Therefore, it is possible to achieve a large capacitance value in a small area and downsizing of the electronic device.

## Description

The present invention relates to an electronic device. In particular, it relates to a technique usefully applied to a radio frequency module (RF module) including filters and the like for reducing radio frequency distortion.

Several communication protocols are available for mobile communication typified by mobile phones. For example, in Europe, in addition to GSM and EDGE which provides an increased data communication speed of GSM prevailing as a second-generation wireless communication protocol, W-CDMA, the service of which has recently started, is available as a third-generation wireless communication protocol. In the North America, in addition to DCS and PCS as a second-generation wireless communication protocol, cdma1x prevails as a third-generation wireless communication protocol. It should be noted that GSM is an abbreviation of Global System for Mobile Communication; EDGE is an abbreviation of Enhanced Data rate for GSM Evolution; W-CDMA is an abbreviation of Wide-band Code Division Multiple Access; DCS is an abbreviation of Digital Cellular System; PCS is an abbreviation of Personal Communication System; and cdma1x is an abbreviation of Code Division Multiple Access 1x.

In a radio frequency circuit section of a mobile phone handset supporting GSM and EDGE, an antenna switch is disposed between a radio frequency power amplifier and an antenna. The antenna switch has a function to switch over between a transmission slot and a reception slot of a TDMA (time division multiple access) system.

On the other hand, as another tendency regarding the radio frequency circuit configuration in mobile phone handsets, an output power detection circuit has been increasingly incorporated in a radio frequency power amplifier module including a radio frequency power amplifier. For example, "Accurate Power Control Technique for Handset PA Modules with Integrated Directional Couplers", Jelena Madic et al., 2003 IEEE Radio Frequency Integrated Circuits Symposium pp. 715-718 (Non-Patent Document 1) discloses that a directional coupler for detecting the power generated by a power amplifier is integrated with the power amplifier in a power amplifier module. A main line of the directional coupler is connected between the output of the power amplifier and the antenna, and a sub line of the directional coupler is connected between a terminating resistor and the input of a power level control unit. The directional coupler can detect a detection voltage of a vectorial sum of a coupling voltage obtained from a progressive wave signal generated by the power amplifier and a coupling voltage obtained from a reflection wave signal reflected by a load.

Also, "A Highly Integrated Quad-Band GSM TX-Front-End-Module", P. DiCarlo et al., 2003 IEEE Gallium Arsenide Integrated Circuit (GaAsIC) Symposium, 2003, 25th Annual Technical Digest. pp. 280-283 (Non-Patent Document 2) discloses a highly integrated quad-band transmit front-end module that incorporates a power amplifier, an amplification controller, a transmission/reception switch, a switch controller, a dual band directional coupler, a diplexer, a matching circuit and a high frequency filter. The quad-band means multiple bands of UGSM (GSM850), EGSM (GSM900), DCS (DCS1880) and PCS (PCS1900) for mobile phones. This module employs InGaP/GaAs HBT (heterojunction bipolar transistor), AlGaAs/InGaAs/AlGaAs PHEMT, GaAs Schottky/passive, and Si Schottky/bipolar/CMOS semiconductor technologies.

In the front-end module as disclosed in the Non-Patent Document 2, a plurality of inductors and capacitors are used. For example, FIG. 8 of Japanese Patent Application Laid-Open Publication No. 2005-268447 (Patent Document 1) shows a configuration in which C-shaped coil patterns are formed on the surfaces of the respective layers of a build-up multilayer substrate, and these coil patterns on the respective layers are connected to each other by build-up via. This configuration forms a spiral-shaped inductor (generally, called as spiral inductor or the like) as a whole.

FIG. 1 of Japanese Patent Application Laid-Open Publication No. 2006-59999 (Patent Document 2) shows a configuration including a stacked body formed by stacking component layers, internal conductors disposed on the component layers and a via hole for electrically connecting these internal conductors. The configuration also forms a spiral inductor similar to the Patent Document 1. Further, FIG. 11 of the Patent Document 2 shows a configuration including a stacked body formed by stacking component layers, internal conductors with a plane shape formed on the component layers, and terminal electrodes provided at the both ends of the stacked body, in which adjacent internal conductors are connected to different terminal electrodes. This configuration forms a capacitor.

FIG. 1 of Japanese Patent Application Laid-Open Publication No. 2004-296927 (Patent Document 3) shows a configuration in which, in five-layered dielectric layers, a line-shaped conductor is formed between a second layer and a third layer, a capacitive electrode is formed on a fourth layer, two ground capacitive electrodes are formed on a fifth layer, and the rear surface of the fifth layer serves as a ground electrode. In this configuration, one end of the line-shaped conductor on the second layer is connected to the capacitive electrode on the fourth layer and one ground capacitive electrode on the fifth layer via a through conductor, and the other end thereof is connected to one end of the line-shaped conductor on the third layer via a through conductor. Also, the other end of the line-shaped conductor on the third layer is connected to the other ground capacitive electrode on the fifth layer via a through conductor. This configuration forms a low-pass filter constituted of an LC parallel resonant circuit and capacitors connected to both ends of the LC parallel resonant circuit.

In mobile communication devices typified by mobile phones, requests for downsizing, high integration and cost reduction of the component parts have been increasing in recent years. In a mobile communication device, a component called as radio frequency (RF) module that performs transmission/reception of radio frequency signals with an antenna is provided. In addition to the requests for multi-function, downsizing and cost reduction of the mobile communication devices, downsizing of the RF module has also been required.

In general, the RF module includes an antenna switch circuit, a power amplifier circuit, an input/output matching circuit, and various filter circuits. Among them, the output matching circuit and various filter circuits can be formed on a multilayer wiring substrate, on which semiconductor chips (power amplifier circuit and others) are mounted, with utilizing the wiring patterns thereof. Therefore, for the achievement of downsizing or cost reduction of the RF module, downsizing or cost reduction of such wiring patterns is particularly advantageous.

When forming output matching circuits and various filter circuits on a multilayer wiring substrate, for example, it is possible to utilize the inductors and capacitors disclosed in the Patent Document 1 to 3. However, when various filter circuits or the like are configured by combining the spiral inductor and the capacitor disclosed in the Patent Document 1 and the Patent Document 2, since the circuit area increases and about ten layers of wiring substrates are required in some cases for the layout of the wirings, downsizing or cost reduction is difficult to be achieved. Further, when the technique of the Patent Document 3 is utilized, the downsizing or cost reduction can be achieved to a certain extent. However, since the inductor can be formed in only two layers, the inductance is insufficient, and therefore, it can be applied only to the filters for a relatively higher frequency in a practical basis. Furthermore, when viewed from the top in projection, the configuration disclosed in the Patent Document 3 has a capacitor formed adjacent to an inductor. Therefore, there is concern about increase in circuit area.

On the other hand, another problem conceivable during the progress of the downsizing and high integration of the RF module is a return path via the multilayer wiring substrate. For example, when an output signal from the power amplifier circuit returns to the input side via the return path on the multilayer wiring substrate, an oscillation phenomenon or the like occurs. The oscillation phenomenon gives noises in unnecessary band to interfere with transmission/reception signals in other bands, and therefore, it causes the malfunction and infringes the Radio Law. For the achievement of the downsizing and high integration of the RF module, it is indispensable to solve the problem of the return path.

Moreover, in addition to the above-described return path, a problem of leakage path as follows may occur. For example, by using a directional coupler integrated in a power amplifier module as disclosed in the Non-Patent Document 1, it is possible to detect a detection voltage of a vectorial sum of a coupling voltage obtained from a progressive wave signal generated by the power amplifier and a coupling voltage obtained from a reflection wave signal reflected by a load. Meanwhile, in addition to the integration of the directional coupler in the RF module together with the RF power amplifier, by integrating the output matching circuit of the RF power amplifier, the harmonic elimination filter and an antenna switch as disclosed in the Non-Patent Document 2, it is expected to develop a high functional RF module capable of achieving further downsizing of the mobile phone handset.

Prior to the present invention, the inventors of the present invention have engaged in development of an RF module to be mounted in a mobile phone, which enables multi-band transmission of GSM850, GSM900, DCS1800 and PCS1900.

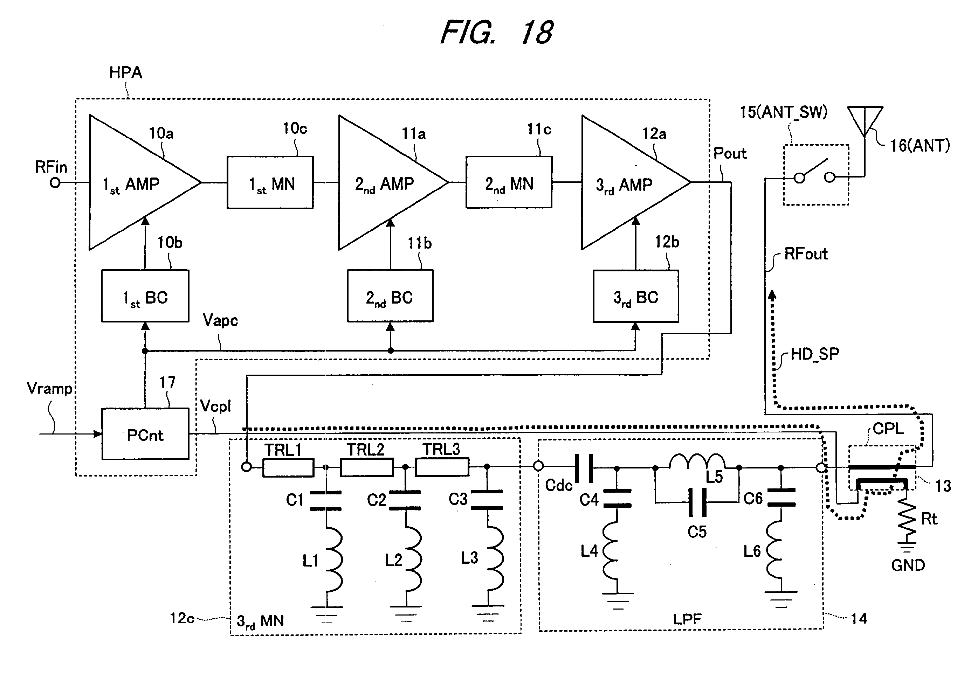

FIG. 18 is a diagram showing a circuit configuration of an RF module examined by the inventors of the present invention during the development prior to the present invention. The RF module includes an RF power amplifier HPA, an output matching circuit 12c located at a final stage, a harmonic elimination filter (LPF) 14, a directional coupler (CPL) 13 and an antenna switch (ANT_SW) 15. The antenna switch 15 is connected to an antenna (ANT) 16 of a mobile phone outside the RF module.

The RF power amplifier HPA is formed in a chip of a monolithic semiconductor integrated circuit and includes an initial-stage amplifier 10a, an initial-stage bias circuit 10b, a first interstage matching circuit 10c, a second-stage amplifier 11a, a second-stage bias circuit 11b, a second interstage matching circuit 11c, a final-stage amplifier 12a, a final-stage bias circuit 12b and a gain control unit 17.

To an initial-stage RF input terminal of the initial-stage amplifier 10a, an RF amplification signal RFin is supplied, and the initial-stage RF amplification output signal from the initial-stage amplifier 10a is supplied to a second-stage RF input terminal of the second-stage amplifier 11a via the first interstage matching circuit 10c. The second-stage RF amplification output signal from the second-stage amplifier 11a is supplied to a final-stage RF input terminal of the final-stage amplifier 12a via the second interstage matching circuit 11c.

To the gain control unit 17, a gain control signal Vramp from a base band signal processing unit and a detection voltage Vcpl from the directional coupler (CPL) 13 are supplied via an RF analog signal processing semiconductor integrated circuit. Note that the level of the gain control signal Vramp is in proportion to the distance between a base station and a mobile phone, and the level of an RF transmission signal RFout supplied from the RF power amplifier HPA to the antenna (ANT) 16 can be controlled based on the level of the gain control signal Vramp. The gain control unit 17 performs APC (automatic power control) operation by controlling the gain of the RF power amplifier HPA so that the level of the detection voltage Vcpl from the directional coupler (CPL) 13 follows the level of the gain control signal Vramp. The APC is carried out by the gain control of the initial-stage amplifier 10a, the second-stage amplifier 11a and the final-stage amplifier 12a by the initial-stage bias circuit 10b, the second-stage bias circuit 11b and the final-stage bias circuit 12b which are controlled by the gain control unit 17.

The final-stage RF amplification output signal from the final-stage amplifier 12a of the RF power amplifier HPA is supplied to the RF signal input terminal of the harmonic elimination filter (LPF) 14 via the output matching circuit 12c at the final stage located outside the monolithic semiconductor integrated circuit chip. The harmonic elimination filter (LPF) 14 transmits a basic frequency component of the RF signal, which is supplied to the RF signal input terminal, to the RF signal output terminal at an extremely small attenuation rate. However, harmonic components such as double harmonic, triple harmonic and quadruple harmonic are attenuated at a large attenuation rate. The RF signal from the RF signal output terminal of the harmonic elimination filter (LPF) 14 is supplied to one end of the antenna switch (ANT_SW) 15 via the main line of the directional coupler (CPL) 13, and the other end of the antenna switch (ANT_SW) 15 is connected to one end of the antenna (ANT) 16. The one end and the other end of the sub line of the directional coupler (CPL) 13 are connected to the terminating resistor Rt and the detection voltage input terminal of the gain control unit 17, respectively.

However, according to the result of the examination prior to the present invention by the inventors of the present invention, it has been found that the radio frequency characteristics of the RF module shown in FIG. 18 do not satisfy the design target. When the radio frequency characteristics do not satisfy the design target in the RF module, high level harmonic components contained in the RF transmission signal transmitted from a mobile phone become an interfere signal for the adjacent channels. The level of the harmonic component contained in the RF transmission signal is represented with ACPR (adjacent channel leakage power ratio). Incidentally, ACPR is an abbreviation of Adjacent Channel Leakage Power Ratio.

Further, the present inventors have analyzed the cause why the harmonic characteristics of the RF module shown in FIG. 18 do not satisfy the design target. As a result, the following conclusions can be obtained. That is, as indicated by a broken line HD_SP in FIG. 18, the harmonic component contained in a final-stage RF amplification output signal from the final-stage amplifier 12a of the RF power amplifier HPA is transmitted to the antenna 16. The signal path indicated by the broken line HD_SP includes a signal line between a sub line of the directional coupler (CPL) 13 and the gain control unit 17, a sub line and a main line of the directional coupler 13 and the antenna switch 15. Between the final-stage amplifier 12a and the main line of the directional coupler 13, the output matching circuit 12c at the final stage and the harmonic elimination filter 14, which attenuate the harmonic component at a large attenuation rate, are connected. However, the signal path indicated by the broken line HD_SP bypasses the output matching circuit 12c at the final stage and the harmonic elimination filter 14. As a result, the harmonic component from the final-stage amplifier 12a is transmitted to the antenna 16 via the signal line between the sub line of the directional coupler 13 and the gain control unit 17, and the sub line and the main line of the directional coupler 13.

Then, an object of the present invention is to permit downsizing or cost reduction of an electronic device such as the RF module. Another object of the present invention is to permit downsizing of the RF module by preventing the high level harmonic component from an RF power amplifier from being transmitted to the antenna via the signal line between the sub line of the directional coupler and the gain control unit and the sub line and the main line of the directional coupler. The above and other objects and novel characteristics of the present invention will be apparent from the description of this specification and the accompanying drawings.

In a resonant circuit according to an embodiment of the present invention, a multilayer wiring substrate is used, a first wiring pattern in a first wiring layer and a second wiring pattern in a second wiring layer adjacent to the first wiring layer are formed into a shape having at least an inductance element, and further a third wiring pattern of a third wiring layer different from the first and second wiring layers is formed into a shape having an inductance element (inductor pattern). Also, one end of the first wiring pattern serves as an input or output node and the other end thereof is connected to one end of the inductor pattern via a via hole conductor. On the other hand, one end of the second wiring pattern serves as an output or input node and the other end thereof is connected to the other end of the inductor pattern via a via hole conductor.

As described above, by disposing the input or output node to one of the first wiring pattern and the second wiring pattern adjacent to each other and disposing the output or input node to the other, the capacitance value between the input node and the output node can be increased compared to the case where the nodes are disposed to the wiring layers not adjacent to each other. Therefore, since a sufficient capacitance value can be ensured in a small area, a downsized or low-cost parallel resonant circuit can be achieved. Further, by applying the parallel resonant circuit to a filter circuit of an RF module or the like, downsizing or cost reduction of the module can be realized. Incidentally, by increasing the maximum line width of the first wiring pattern and the second wiring pattern to be larger than the maximum line width of the inductor pattern, the capacitance value can be further increased.

Further, a resonant circuit according to an embodiment of the present invention is formed on a multilayer wiring substrate including a first wiring layer, a second wiring layer disposed on below the first wiring layer, a third wiring layer below the second wiring layer and a fourth wiring layer disposed below the third wiring layer, which comprises: (1) a first wiring pattern formed in the first wiring layer so as to include an approximately loop-shaped line, and having a first node for inputting or outputting a signal at one end thereof; (2) a second wiring pattern formed in the second wiring layer so as to include an approximately loop-shaped line, and having a second node for inputting or outputting a signal at one end thereof; (3) a third wiring pattern formed into a plane shape in the third wiring layer; (4) and a fourth wiring pattern formed into a plane shape in the fourth wiring layer.

Further, the other end of the first wiring pattern and the other end of the second wiring pattern are electrically connected to each other via a first via hole conductor, the third wiring pattern and the fourth wiring pattern are disposed opposing to each other, one pattern of the third wiring pattern and the fourth wiring pattern is electrically connected to the first node via a second via hole conductor, and the other pattern of the third wiring pattern and the fourth wiring pattern is electrically connected to the second node via a third via hole conductor. Further, the first wiring pattern, the second wiring pattern, the third wiring pattern and the fourth wiring pattern are formed so as to overlap each other, and an overlapping area of the third wiring pattern and the fourth wiring pattern is larger than an overlapping area of the second wiring pattern and the third wiring pattern.

As described above, by forming the input node and the output node on the two wiring layers adjacent to each other, similar to that described above, the capacitance value between the nodes can be increased. Further, by connecting the input node and the output node to the wiring patterns (capacitive patterns) each formed into a plane shape in the third and fourth wiring layers, the capacitance value can be further increased. By this means, a downsized or low-cost parallel resonant circuit can be realized, and by applying the resonant circuit to a filter circuit of an RF module or the like, downsizing or cost reduction of the module can be achieved. Incidentally, by arranging the occupied areas of the first wiring pattern, the second wiring pattern and the capacitive pattern to have a relationship that any one of the occupied area includes the other occupied areas when viewed from the top, the further downsizing can be achieved.

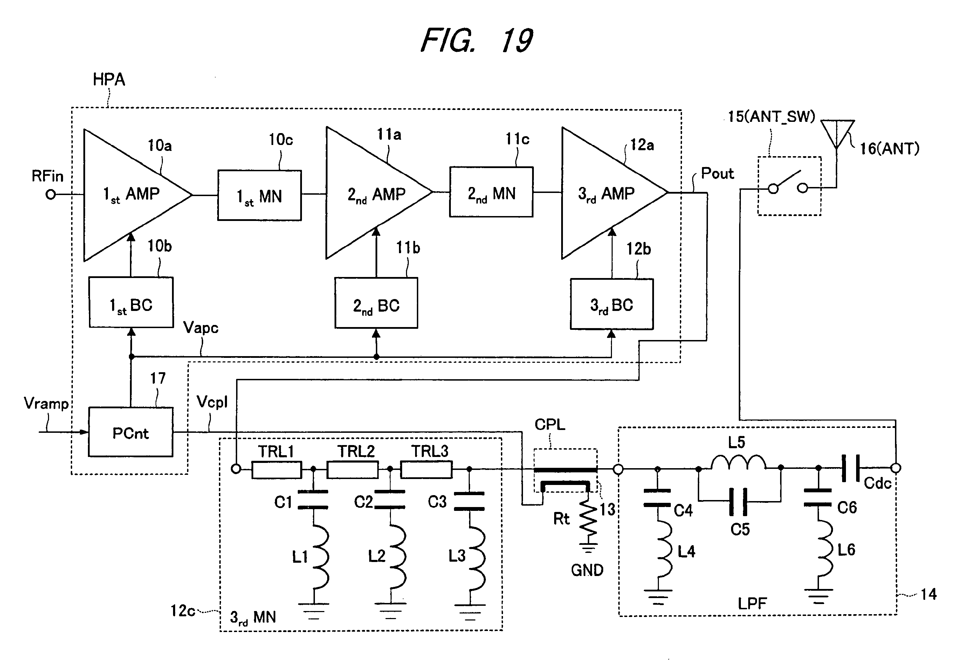

Also, the RF module according to an embodiment of the present invention includes an RF power amplifier (HPA), an output matching circuit (12c), a directional coupler (13) and a harmonic elimination filter (14). The output amplification signal (Pout) of the RF power amplifier is supplied to the input terminal of the output matching circuit, and the RF signal from the output terminal of the output matching circuit is supplied to the input terminal of the harmonic elimination filter via the main line of the directional coupler. The detection signal (Vcpl) from the sub line of the directional coupler is supplied to the signal input terminal of the gain control unit (17) of the RF power amplifier (HPA). The RF signal from the output terminal of the harmonic elimination filter can be transmitted to the antenna (16) (refer to FIG. 19).

According to the configuration described above, even when a harmonic component of the output amplification signal (Pout) from the RF power amplifier is transmitted to the signal line between the sub line of the directional coupler (13) and the gain control unit (17) and to the sub line and main line of the directional coupler (13), since the harmonic elimination filter (14) is connected between the main line of the directional coupler (13) and the antenna (16), it is possible to prevent the high level harmonic component from the output of the RF power amplifier from being transmitted to the antenna via the signal line between the sub line of the directional coupler and the gain control unit and via the sub line and the main line of the directional coupler.

By using the electronic device and RF module according to an embodiment of the present invention, downsizing or cost reduction can be achieved.

### IN THE DRAWINGS

FIG. 1 is a block diagram showing an example of a configuration of an RF module according to a first embodiment of the present invention;
FIG. 2A is a perspective view showing a configuration example of a resonant circuit according to the first embodiment of the present invention;
FIG. 2B is a plan view showing respective layers of the resonant circuit in FIG. 2A;
FIG. 3A is an equivalent circuit diagram simply illustrating the resonant circuit shown in FIG. 2A and FIG. 2B according to the first embodiment of the present invention;
FIG. 3B is an equivalent circuit diagram simply illustrating a general spiral inductor as a comparative example;
FIG. 4 is a perspective view showing a configuration example of major parts of the resonant circuit in FIG. 2A and FIG. 2B viewed transparently;
FIG. 5A is a perspective view showing a configuration example of a resonant circuit according to a second embodiment of the present invention;
FIG. 5B is a plan view showing respective layers of the resonant circuit in FIG. 5A;
FIG. 6 is an equivalent circuit diagram simply illustrating the parallel resonant circuit in FIG. 5A and FIG. 5B;
FIG. 7A is a perspective view showing a configuration example of major parts of the resonant circuit in FIG. 5A and FIG. 5B viewed transparently according to the second embodiment of the present invention;
FIG. 7B is a perspective view showing a comparative configuration example of the resonant circuit in FIG. 7A;
FIG. 8 is a circuit diagram showing a configuration example of an RF module according to a third embodiment of the present invention;
FIG. 9 is a circuit diagram showing a configuration example of a periphery of a power amplifier circuit in an RF module examined as a premise of the present invention;
FIG. 10 is a circuit diagram showing a configuration example of a periphery of a power amplifier circuit in an RF module according to a fourth embodiment of the present invention;
FIG. 11A is a layout diagram corresponding to the configuration of a wiring substrate in the periphery of the power amplifier circuit in the RF module shown in FIG. 9 as a comparative example;
FIG. 11B is a layout diagram corresponding to the configuration of a wiring substrate in the periphery of the power amplifier circuit in the RF module shown in FIG. 10 according to the fourth embodiment of the present invention;
FIG. 12A is a perspective view of an entire wiring substrate viewed transparently for illustrating a configuration example of a wiring substrate corresponding to FIG. 10 in the RF module according to the fourth embodiment of the present invention;
FIG. 12B is an enlarged perspective view of the periphery of the power amplifier circuit in the RF module in FIG. 12A;
FIG. 12C is a perspective view of FIG. 12B in which a first wiring layer is omitted;
FIG. 13A is a graph showing an evaluation result of a return gain value in the configuration in FIG. 9 (comparative example);
FIG. 13B is a graph showing an evaluation result of a return gain value in the configuration in FIG. 10;
FIG. 14 is a diagram showing a result of current density analysis in the configuration in FIG. 9 (comparative example) and the configuration in FIG. 10;
FIG. 15 is a diagram showing a result of current density analysis in the configuration in FIG. 9 (comparative example) and the configuration in FIG. 10;
FIG. 16 is a diagram showing a result of current density analysis in the configuration in FIG. 9 (comparative example) and the configuration in FIG. 10;
FIG. 17A is a schematic diagram illustrating a preferred application example of the configuration example in FIG. 10;
FIG. 17B is a schematic diagram illustrating another preferred application example of the configuration example in FIG. 10;
FIG. 18 is a diagram showing a circuit configuration of an RF module examined by the inventors of the present invention during the development prior to the present invention;
FIG. 19 is a diagram showing a circuit configuration of an RF module according to a fifth embodiment of the present invention;
FIG. 20 is a diagram showing a circuit configuration of an RF module according to a sixth embodiment of the present invention;
FIG. 21A is a diagram showing the wirings around a chip of the RF module in FIG. 20;
FIG. 21B is a perspective view showing the wirings around a chip of the RF module in FIG. 20;
FIG. 22 is a diagram showing a circuit configuration of a specific RF module according to a seventh embodiment of the present invention;
FIG. 23 is a block diagram showing a configuration of a mobile phone in which the RF module shown in FIG. 22, a radio frequency analog signal processing semiconductor integrated circuit and a base band signal processing LSI are mounted; and
FIG. 24 is a circuit diagram showing an antenna switch microwave monolithic semiconductor integrated circuit constituting an antenna switch of the RF module shown in FIG. 22.

### <Representative embodiments>

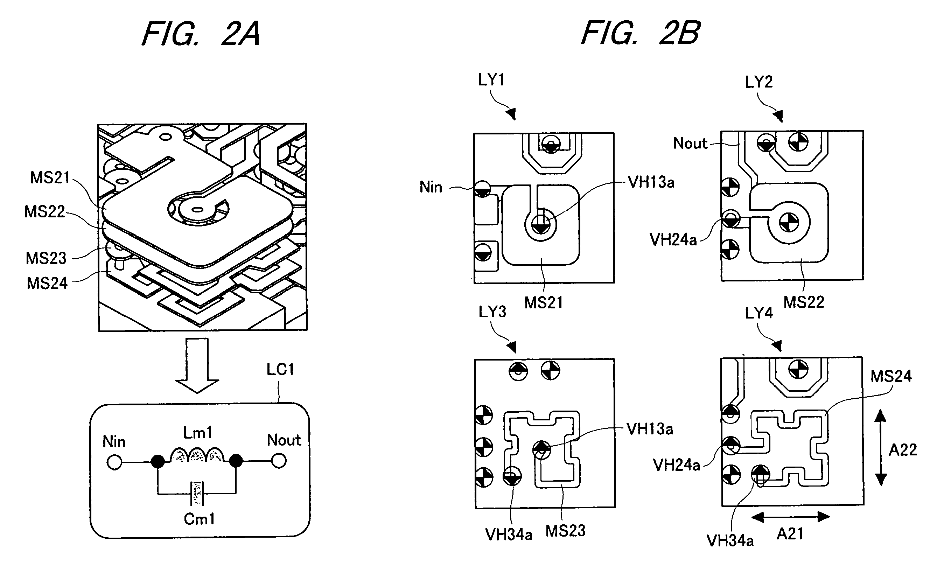

First of all, an outline of representative embodiments of the present invention disclosed in this application will be described. It should be noted that reference numerals and symbols in the figures which will be referred to in parentheses in the following description of the representative embodiments are given only for exemplifying the conceptions of the components to which the reference numerals and symbols are applied.
[1] An electronic device according to a representative embodiment of the present invention is achieved by a multilayer wiring substrate that includes a first wiring layer (LY1), a second wiring layer (LY2) disposed below the first wiring layer, a third wiring layer (LY3) disposed below the second wiring layer. Here, the electronic device includes: a first wiring pattern (MS21) that is formed into an approximately loop-shaped line in the first wiring layer and has one end functioning as a first node (Nin); a second wiring pattern (MS22) that is formed into an approximately loop-shaped line in the second wiring layer and has one end functioning as a second node (Nout); inductor patterns (MS23 and MS24) that are formed into a single or a plurality of approximately loop-shaped lines in the third wiring layer or over the third wiring layer and its underlying layers; a first via hole conductor (VH13a) that electrically connects between the other end of the first wiring pattern and one end of the inductor pattern; and a second via hole conductor (VH24a) that electrically connects between the other end of the second wiring pattern and the other end of the inductor pattern, in which the first wiring layer and the second wiring layer are located adjacent to each other (refer to FIG. 2A and FIG. 2B).

In an electronic device according to a more specific embodiment, the multilayer wiring substrate further includes a fourth wiring layer (LY4) disposed below the third wiring layer (LY3). The third wiring layer includes the third wiring pattern (MS23) that is formed into an approximately loop-shaped line and constitutes a part of the inductor pattern. The fourth wiring layer includes the fourth wiring pattern (MS24) that is formed into an approximately loop-shaped line and constitutes another part of the inductor pattern. Here, one end of the third wiring pattern is connected to the other end of the first wiring pattern via the first via hole conductor (VH13a), the other end of the third wiring pattern is electrically connected to one end of the fourth wiring pattern via a third via hole conductor (VH34a), and the other end of the fourth wiring pattern is electrically connected to the other end of the second wiring pattern via the second via hole conductor (VH24a) (refer to FIG. 2A and FIG. 2B).

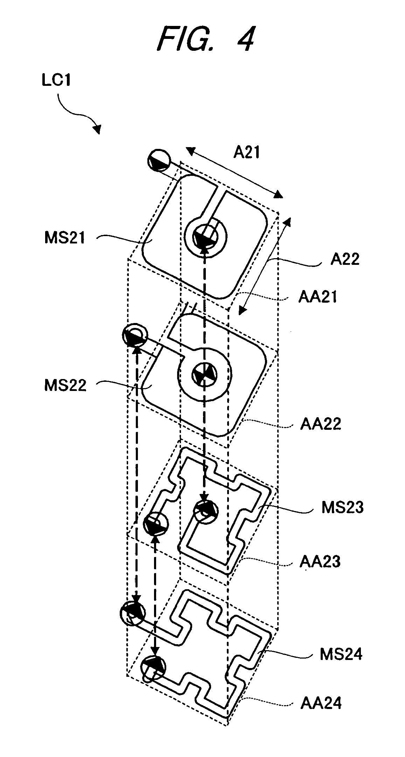

In an electronic device according to a more preferred embodiment, the first wiring pattern, the second wiring pattern and the inductor pattern are arranged so that the occupied areas of the first wiring pattern, the second wiring pattern and the capacitive pattern (AA21 to AA24) have such a relationship that any one of the occupied area includes the other occupied areas when viewed from the top (refer to FIG. 4).

Further, in an electronic device according to still another preferred embodiment, the maximum line width of the first wiring pattern (MS21) and the second wiring pattern (MS22) is larger than the maximum line width of the inductor pattern (MS23 and MS24).

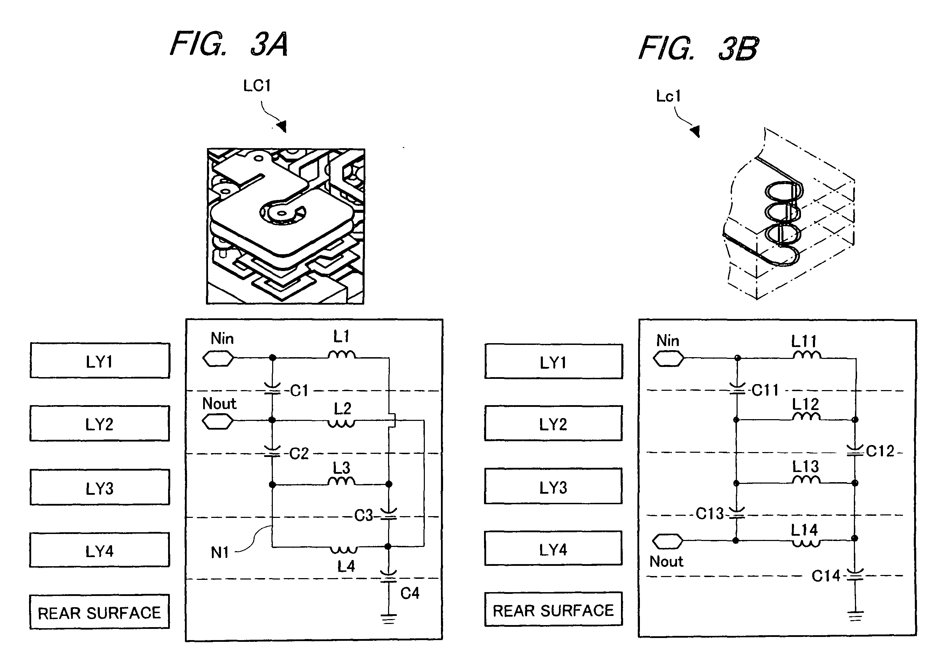

Further, in an electronic device according to still another preferred embodiment, a bottom layer or a top layer of the multilayer wiring substrate serves as a ground electrode (refer to FIG. 3A and FIG. 3B).

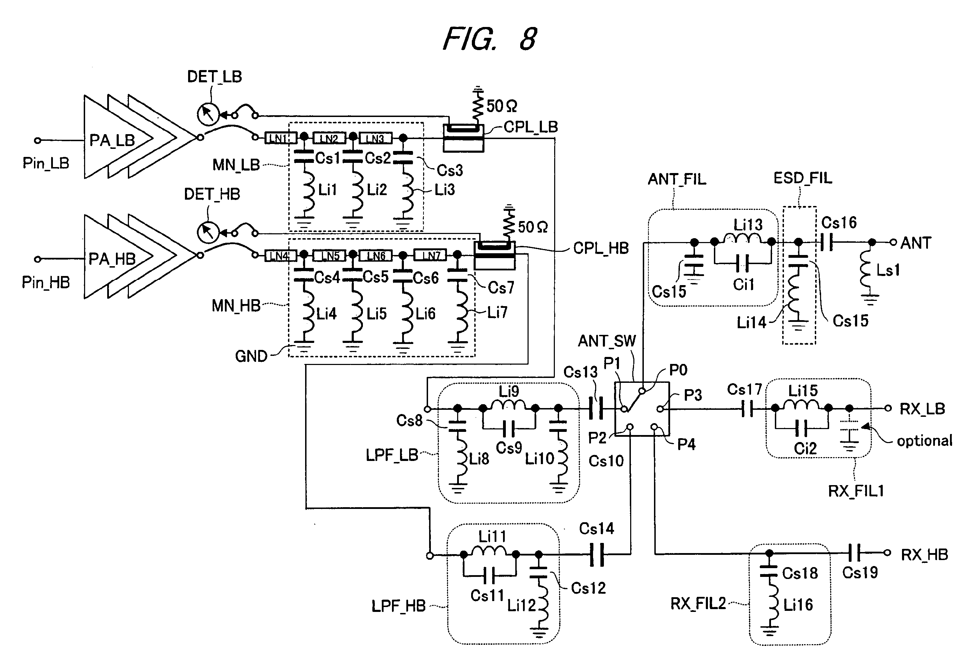

Further, in an electronic device according to still another preferred embodiment, the electronic device as described above is included in band elimination filters (LPF_HB, LPF_LB, ANT_FIL and RX_FIL) (refer to FIG. 8).

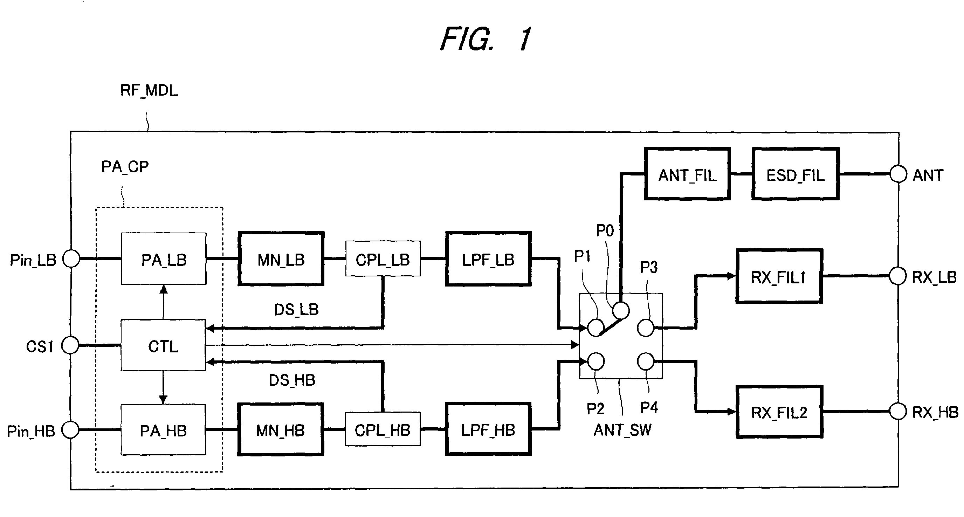

Further, in an electronic device according to still another preferred embodiment, the electronic device as described above is included in the band elimination filters (LPF_HB, LPF_LB, ANT_FIL, RX_FIL) for harmonic attenuation formed in the multilayer wiring substrate. On the multilayer wiring substrate, a first semiconductor chip (PA_CP) including a power amplifier circuit and a second semiconductor chip including an antenna switch circuit (ANT_SN) are mounted, and the band elimination filter is connected to the antenna switch circuit (refer to FIG. 1 and FIG. 8).

As described above, in the electronic device according to the representative embodiment of the present invention, a multilayer wiring substrate is used, a first wiring pattern in a first wiring layer and a second wiring pattern in a second wiring layer adjacent to the first wiring layer are formed into a shape having at least an inductance element, and further a layer different from the first and second wiring layers is formed into an inductor pattern. Also, one end of the first wiring pattern serves as an input or output node and the other end thereof is connected to one end of the inductor pattern via a via hole conductor. On the other hand, one end of the second wiring pattern serves as an output or input node and the other end thereof is connected to the other end of the inductor pattern via a via hole conductor. That is, the electronic device functions as a parallel resonant circuit.

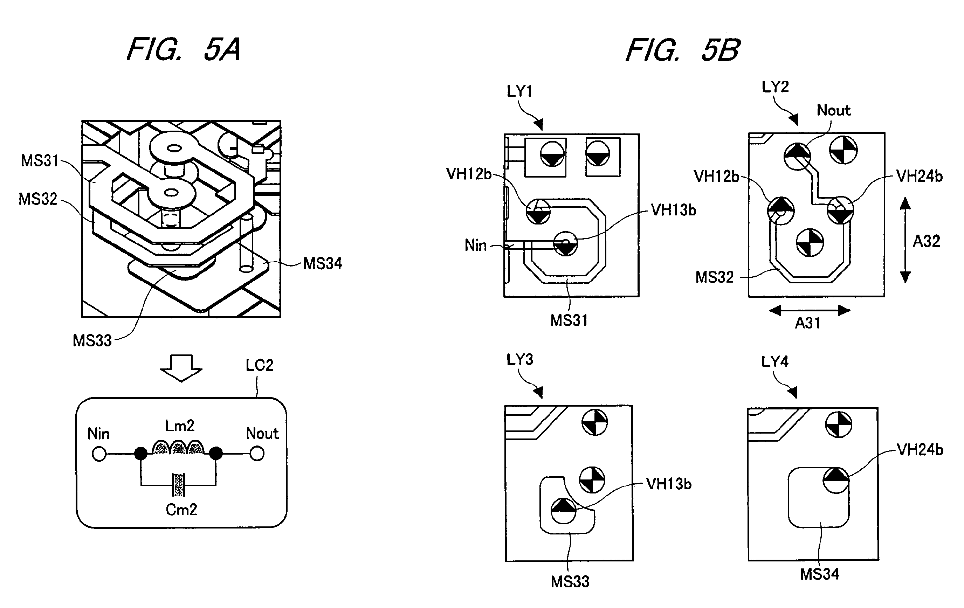

As described above, by disposing the input node or output node at one of the two wiring layers adjacent to each other and disposing the output node or input node at the other wiring layer, the capacitance value between the input node and the output node can be increased compared to the case where the nodes are disposed to the wiring layers not adjacent to each other. Therefore, since a sufficient capacitance value can be ensured in a small area, a downsized or low-cost parallel resonant circuit can be achieved. Further, by applying the parallel resonant circuit to a filter circuit of an RF module or the like, downsizing or cost reduction of the module can be realized. Incidentally, by increasing the maximum line width of the first wiring pattern and the second wiring pattern to be larger than the maximum line width of the inductor pattern, the capacitance value can be further increased. Also, by using the bottom layer or top layer of the multilayer wiring substrate as a ground electrode, the inductance value of the parallel resonant circuit can be appropriately adjusted in accordance with the relationship in distance between the ground electrode and the wiring patterns and between the ground electrode and the inductor pattern.
[2] An electronic device according to another aspect of the embodiment of the present invention is achieved by a multilayer wiring substrate that includes a first wiring layer (LY1), a second wiring layer (LY2) disposed below the first wiring layer, a third wiring layer (LY3) disposed below the second wiring layer and a fourth wiring layer (LY4) disposed below the third wiring layer. Here, the electronic device includes: a first wiring pattern (MS31) that is formed into an approximately loop-shaped line in the first wiring layer and has one end functioning as a first node (Nin); a second wiring pattern (MS32) that is formed into an approximately loop-shaped line in the second wiring layer and has one end functioning as a second node (Nout); a third wiring pattern (MS33) that is formed into a plane shape in the third wiring layer; a fourth wiring pattern (MS34) that is formed into a plane shape in the fourth wiring layer; a first via hole conductor (VH12b) that electrically connects the other end of the first wiring pattern and the other end of the second wiring pattern; a second via hole conductor; and a third via hole conductor. Here, the third wiring pattern and the fourth wiring pattern include surfaces that are opposing to each other. One of the third wiring pattern and the fourth wiring pattern is electrically connected to the first node via the second via hole conductor (VH13b or VH24b). The other of the third wiring pattern and the fourth wiring pattern is electrically connected to the second node via the third via hole conductor (VH24b or VH13b). The first wiring layer (LY1) and the second wiring layer (LY2) are the wiring layers adjacent to each other (refer to FIG. 5A and FIG. 5B).

Here, in an electronic device according to a more specific embodiment, the third wiring pattern (MS33) is electrically connected to the first node (Nin) via the second via hole conductor (VH13b), and the fourth wiring pattern (MS34) is electrically connected to the second node (Nout) via the third via hole conductor (VH24b) (refer to FIG. 5A and FIG. 5B).

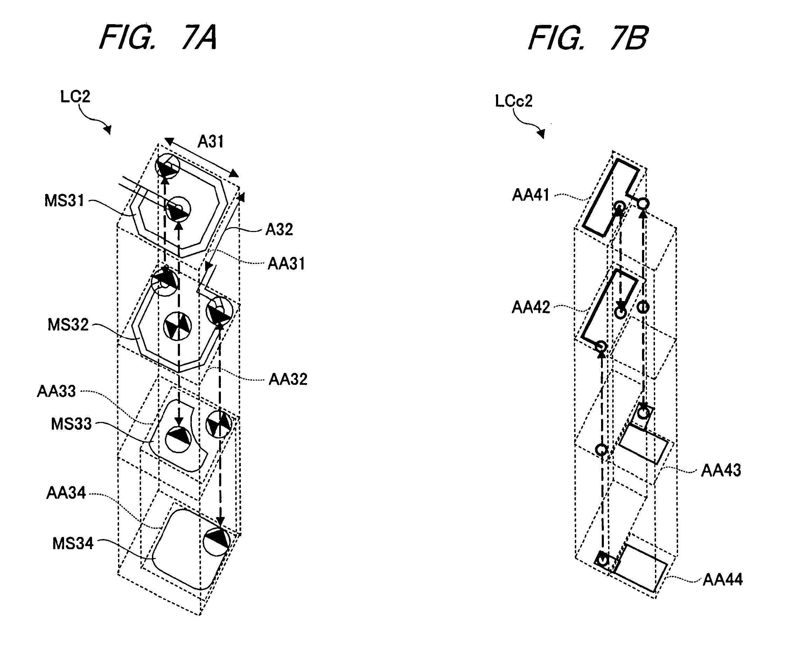

In an electronic device according to a more preferred embodiment, the first to fourth wiring patterns are arranged so that the occupied areas of the first to fourth wiring patterns (AA31 to AA34) have such a relationship that any one of the occupied area includes the other occupied areas when viewed from the top (refer to FIG. 7A and FIG. 7B).

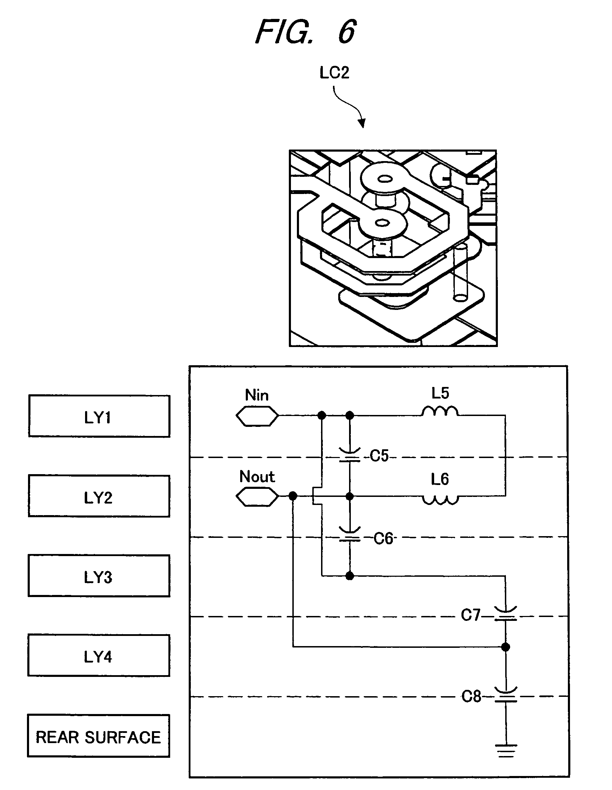

Further, in an electronic device according to another preferred embodiment, the bottom layer of the multilayer wiring substrate is a ground electrode (refer to FIG. 6).

Further, in an electronic device according to still another preferred embodiment, the electronic device as described above is included in band elimination filters (LPF_HB, LPF_LB, ANT_FIL and RX_FIL) (refer to FIG. 8).

Further, in an electronic device according to still another preferred embodiment, the electronic device as described above is included in the band elimination filters (LPF_HB, LPF_LB, ANT_FIL, RX_FIL) for harmonic attenuation formed in the multilayer wiring substrate. On the multilayer wiring substrate, a first semiconductor chip (PA_CP) including a power amplifier circuit and a second semiconductor chip including an antenna switch circuit (ANT_SW) are mounted, and the band elimination filter is connected to the antenna switch circuit (refer to FIG. 1 and FIG. 8).

As described above, in the electronic device according to another aspect of the embodiment, the multilayer wiring substrate is used, the first wiring pattern in the first wiring layer and the second wiring pattern in the second wiring layer adjacent to the first wiring layer are formed into a shape having inductance elements, and further, capacitive patterns are formed in the underlying third wiring layer and fourth wiring layer. The one end of the first wiring pattern serves as the input or output node and is connected to the one end of the capacitive pattern, and the one end of the second wiring pattern serves as the output or input node and is connected to the other end of the capacitive pattern. Further, the other end of the first wiring pattern is connected to the other end of the second wiring pattern or to the other end of the second wiring pattern via the inductor pattern formed on the other layers. That is, the electronic device functions as a parallel resonant circuit.

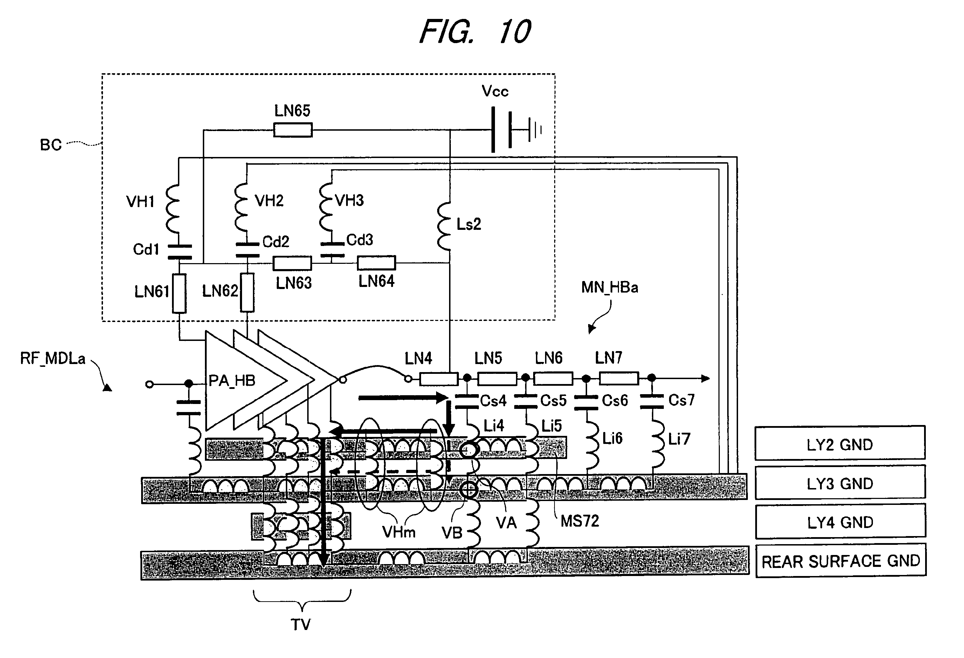

As described above, by forming the input node and the output node at the two wiring layers adjacent to each other, the capacitance value between the nodes can be increased in the same manner as described above. Also, by connecting the input node and output node to the capacitive patterns formed in the third and fourth wiring layers, the capacitance value can be further increased. By this means, a downsized or low-cost parallel resonant circuit can be realized, and by applying the circuit to a filter circuit of an RF module or the like, the reduction in size or cost of the module can be achieved. Also, by arranging the occupied areas of the first wiring pattern, the second wiring pattern and the capacitive pattern to have a relationship that any one of the occupied area includes the other occupied areas when viewed from the top, the further downsizing can be achieved. In addition, by using the bottom layer of the multilayer wiring substrate as a ground electrode, the distance between the ground electrode and the first and second wiring patterns is increased. Thus, the inductance value of the parallel resonant circuit can be sufficiently ensured.
[3] An electronic device according to still another aspect of the embodiment comprises: a multilayer wiring substrate including a first wiring layer and a second wiring layer different from the first wiring layer; a semiconductor chip disposed on the multilayer wiring substrate and including a power amplifier circuit (PA_HB); a first wiring (MS72) for ground voltage formed in the first wiring layer (LY2) and capacitively coupled with the output of the power amplifier circuit; and a second wiring for ground voltage formed in the second wiring layer (LY3) and capacitively coupled with the input of the power amplifier circuit (refer to FIG. 10).

Here, in an electronic device according to a preferred embodiment, in an area located below the semiconductor chip in the multilayer wiring substrate, a formation area of a thermal via (TV) which is considered as an integral ground voltage area by electrically connecting each of the wiring layers via a via hole conductor is provided. The first wiring is connected to the formation area of the thermal via in the first wiring layer, and the second wiring is connected to the formation area of the thermal via in the second wiring layer (refer to FIG. 10).

Further, in an electronic device according to another preferred embodiment, the first wiring and the second wiring are electrically connected via a plurality of via hole conductors (VHm) (refer to FIG. 10).

Further, in an electronic device according to still another preferred embodiment, the first wiring layer is disposed on the second wiring layer (refer to FIG. 10).

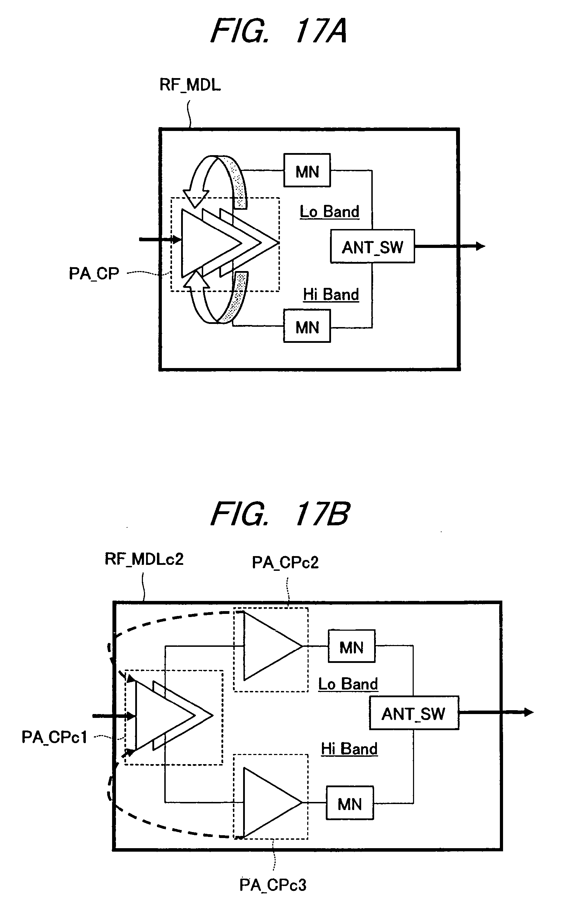

Further, in an electronic device according to still another preferred embodiment, the power amplifier circuit is composed of transistors on multiple stages, and the plurality of transistors on all the stages are formed in the same semiconductor chip (PA_CP) (refer to FIG. 17A and FIG. 17B).

As described above, the electronic device according to still another aspect of the embodiment includes the multilayer wiring substrate on which the semiconductor chip including the power amplifier circuit is mounted, in which the first wiring for ground voltage capacitively coupled with the output of the power amplifier circuit is formed in the first wiring layer of the wiring substrate, and the second wiring for ground voltage capacitively coupled with the input of the power amplifier circuit is formed in the second wiring layer of the wiring substrate. By this means, return current which returns to the input from the output of the power amplifier circuit is reduced. Thus, the electronic device (RF module) can be reduced in size. Further, owing to the reduction in return current, even when the transistors of the respective stages in the current amplification circuit are formed in a single semiconductor chip, a problem such as a malfunction is eliminated, and the RF module can be reduced in size.
[4] An RF module according to a representative embodiment of the invention includes an RF power amplifier (HPA), an output matching circuit (12c), a directional coupler (13) and a harmonic elimination filter (14). An output amplification signal (Pout) of the RF power amplifier is supplied to the input terminal of the output matching circuit, and the RF signal of the output terminal of the output matching circuit is supplied to the input terminal of the harmonic elimination filter via a main line of the directional coupler. A detection signal (Vcpl) from a sub line of the directional coupler is supplied to a signal input terminal of a gain control unit (17) in the RF power amplifier (HPA). The RF signal of the output terminal of the harmonic elimination filter can be transmitted to an antenna (16) (refer to FIG. 19).

According to the embodiment described above, even when a harmonic component of the output amplification signal (Pout) from the RF power amplifier is transmitted to the signal line between the sub line of the directional coupler (13) and the gain control unit (17) and to the sub line and main line of the directional coupler (13), since the harmonic elimination filter (14) is connected between the main line of the directional coupler (13) and the antenna (16), it is possible to prevent the high level harmonic component from the output of the RF power amplifier from being transmitted to the antenna via the signal line between the sub line of the directional coupler and the gain control unit and via the sub line and the main line of the directional coupler.

An RF module according to a preferred embodiment further includes an antenna switch (15) that receives the RF signal from the output terminal of the harmonic elimination filter at one terminal thereof and can transmit the RF signal to the antenna (16) from the other terminal thereof.

According to the preferred embodiment, a high functional RF module can be provided.

In an RF module according to the preferred embodiment, the RF signal from the output terminal of the harmonic elimination filter is supplied to the one terminal of the antenna switch via a DC cut capacitor (Cdc).

According to the preferred embodiment, adjustment of phase rotation in the signal path including the output matching circuit, the directional coupler and the harmonic elimination filter can be facilitated. Also, the distortion at the antenna switch can be reduced. Further, owing to the DC cut capacitor at the output terminal of the harmonic elimination filter, it becomes possible to easily adjust the level of the directional coupling in the directional coupler.

In an RF module according to a preferred embodiment, the RF power amplifier includes multistage amplifiers (10a, 11a and 12a) and bias circuits (10b, 11b and 12c) that are controlled by the gain control unit to control the gain of the multistage amplifiers.

In an RF module according to a specific embodiment, the output matching circuit is provided for reducing the signal reflection due to the difference between the output impedance for generating the output amplification signal (Pout) in the RF power amplifier and the impedance of the antenna (16).

According to the specific embodiment, the deterioration of power efficiency due to the impedance mismatching can be prevented.

In an RF module according to more specific embodiment, the multistage amplifiers, the bias circuits and the gain control unit are formed in a semiconductor integrated circuit chip.

Further, in the RF module according to the specific embodiment, the directional coupler is a microcoupler having a capacitive element connected between the main line and the sub line thereof.
[5] An RF module (100) according to another aspect of an embodiment includes a first RF power amplifier (HPA1), a first output matching circuit (22c), a first directional coupler (23), a first harmonic elimination filter (24), a second RF power amplifier (HPA2), a second output matching circuit (12c), a second directional coupler (13) and a second harmonic elimination filter (14).

The first RF power amplifier is designed to amplify a first frequency band RF signal (Rfin_LB). The second RF power amplifier is designed to amplify a second frequency band RF signal (Rfin_HB) that has a higher frequency than that of the first frequency band RF signal.

The first output amplification signal (Pout_LB) from the first RF power amplifier is supplied to the input terminal of the first output matching circuit, and the first RF signal from the output terminal of the first output matching circuit is supplied to the input terminal of the first harmonic elimination filter via the main line of the first directional coupler. The first detection signal (Vcpl_LB) from the sub line of the first directional coupler is supplied to the first signal input terminal of the first gain control unit (27) for the first RF power amplifier. The first RF signal from the output terminal of the first harmonic elimination filter can be transmitted to the antenna (16).

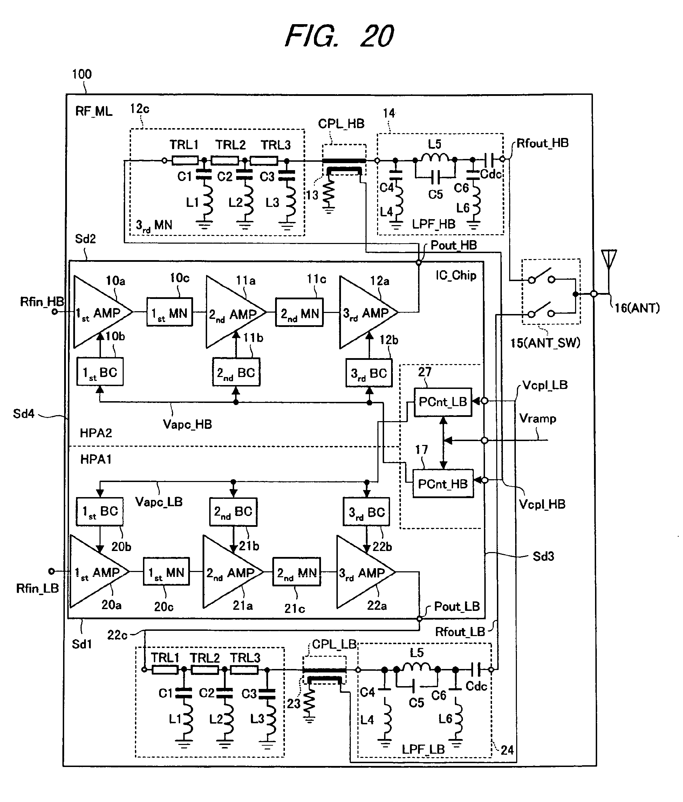

The second output amplification signal (Pout_HB) from the second RF power amplifier is supplied to the input terminal of the second output matching circuit, and the second RF signal from the output terminal of the second output matching circuit is supplied to the input terminal of the second harmonic elimination filter via the main line of the second directional coupler. The second detection signal (Vcpl_HB) from the sub line of the second directional coupler is supplied to the second signal input terminal of the second gain control unit (17) for the second RF power amplifier. The second RF signal from the output terminal of the second harmonic elimination filter can be transmitted to the antenna (refer to FIG. 20).

According to the above embodiment, it is possible to prevent a high level harmonic component of the output from the RF power amplifier which supports multiple bands from being transmitted to the antenna via the signal line between the sub line of the directional coupler and the gain control unit and via the sub line and the main line of the directional coupler.

In an RF module according to a preferred embodiment, the first RF signal from the output terminal of the first harmonic elimination filter is supplied to the first input terminal of the antenna switch (15), and the second RF signal from the output terminal of the second harmonic elimination filter is supplied to the second input terminal of the antenna switch. The RF signal from the output terminal of the antenna switch can be transmitted to the antenna (16).

In an RF module according to a preferred embodiment, the first RF signal from the output terminal of the first harmonic elimination filter is supplied to the first input terminal of the antenna switch via the first DC cut capacitor (Cdc). The second RF signal from the output terminal of the second harmonic elimination filter is supplied to the second input terminal of the antenna switch via the second DC cut capacitor (Cdc).

In the RF module according to a preferred embodiment, the first RF power amplifier, the second RF power amplifier, the first gain control unit and the second gain control unit are formed in a semiconductor integrated circuit chip.

The semiconductor integrated circuit chip has a substantially quadrangular shape. The chip has a first side (Sd1) and a second side (Sd2) which are opposed and substantially parallel to each other. The chip further has a third side (Sd3) which is connected to the first side and the second side and disposed substantially perpendicular to the first side and the second side and a fourth side (Sd4) which is opposed and substantially parallel to the third side.

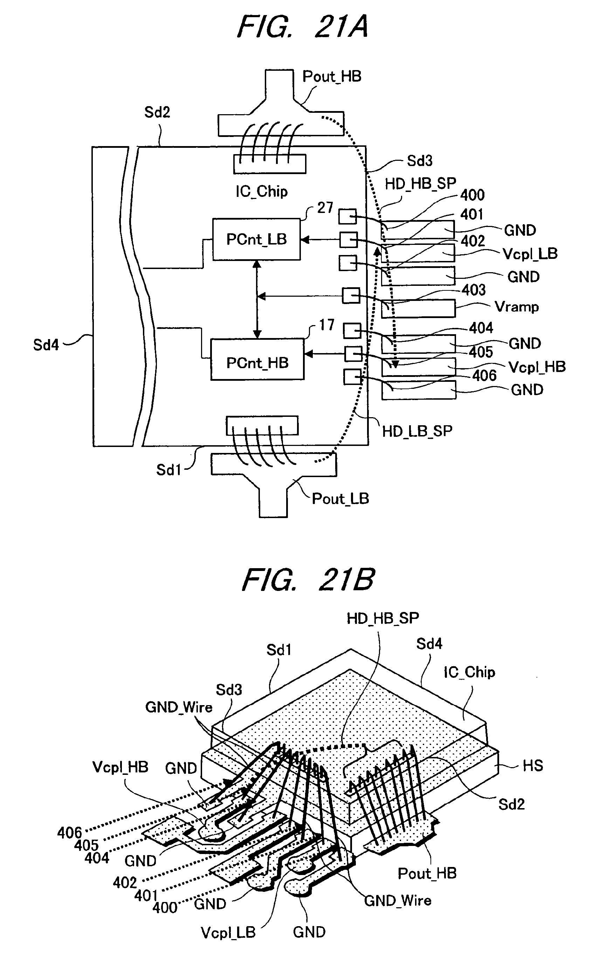

The first output amplification signal (Pout_LB) from the first RF power amplifier is led out from the first side of the chip, and the second output amplification signal (Pout_HB) from the second RF power amplifier is led out from the second side of the chip. The first detection signal (Vcpl_LB) from the sub line of the first directional coupler (23) is led into the first signal input terminal of the first gain control unit (27) for the first RF power amplifier from the third side of the chip. The second detection signal (Vcpl_HB) from the sub line of the second directional coupler (13) is led into the second signal input terminal of the second gain control unit (17) for the second RF power amplifier from the third side of the chip (refer to FIG. 20, FIG. 21A and FIG. 21B).

According to the preferred embodiment described above, a large distance can be ensured between the lead-out point of the first output amplification signal on the first side of the chip and the lead-in point of the first detection signal on the third side of the chip. Also, a large distance can be ensured between the lead-out point of the second output amplification signal on the second side of the chip and the lead-in point of the second detection signal on the third side of the chip. Therefore, the level of the harmonic component of the output amplification signal transmitted to the signal input terminal of the gain control unit can be reduced.

In an RF module according to a more preferred embodiment, the lead-in point of the second detection signal (Vcpl_HB) on the third side is disposed between the lead-out point of the first output amplification signal (Pout_LB) on the first side and the lead-in point of the first detection signal (Vcpl_LB) on the third side. The lead-in point of the first detection signal (Vcpl_LB) on the third side is disposed between the lead-out point of the second output amplification signal (Pout_HB) on the second side and the lead-in point of the second detection signal (Vcpl_HB) on the third side (refer to FIG. 20, FIG. 21A and FIG. 21B).

According to the more preferred embodiment described above, the level of the harmonic component of the output amplification signal transmitted to the signal input terminal of the gain control unit can be further reduced.

In an RF module according to another preferred embodiment, between the lead-out point of the first output amplification signal (Pout_LB) on the first side and the lead-in point of the first detection signal (Vcpl_LB) on the third side, a first ground wiring (402) to be connected to a ground voltage (GND) is connected to the third side. Also, between the lead-out point of the second output amplification signal (Pout_HB) on the second side and the lead-in point of the second detection signal (Vcpl_HB) on the third side, a second ground wiring (404) to be connected to the ground voltage (GND) is connected to the third side (refer to FIG. 21A and FIG. 21B).

In an RF module according to a specific embodiment, the first ground wiring (402) is disposed adjacent to the third side between the lead-in point of the second detection signal (Vcpl_HB) and the lead-in point of the first detection signal (Vcpl_LB). The second ground wiring (404) is disposed adjacent to the third side between the lead-in point of the first detection signal (Vcpl_LB) and the lead-in point of the second detection signal (Vcpl_HB) (refer to FIG. 21A and FIG. 21B).

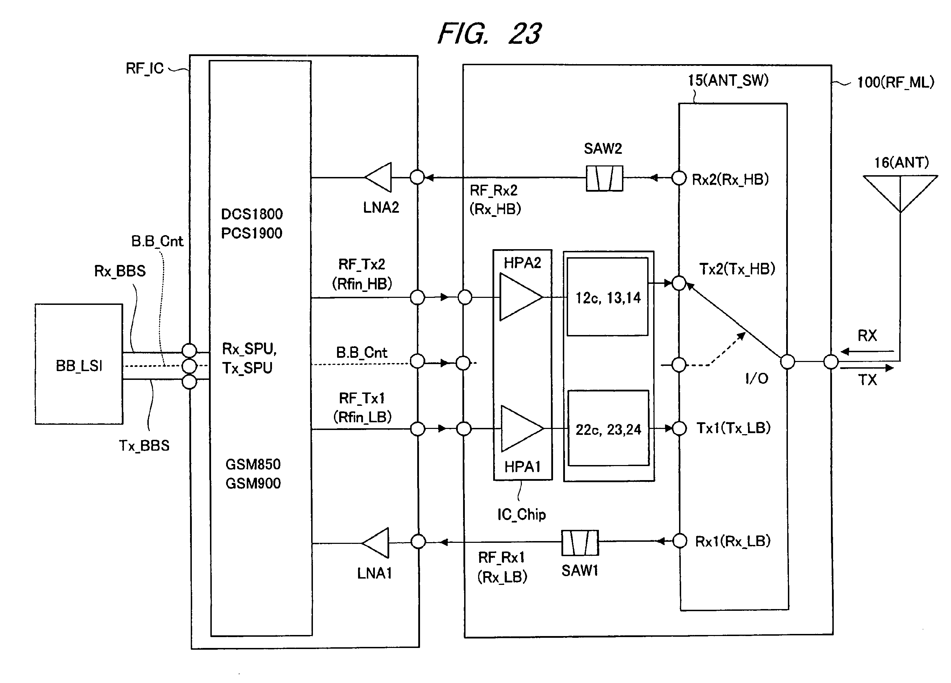

Moreover, in an RF module according to a more specific embodiment, a first frequency band RF signal (Rfin_LB) is an RF transmission signal for GSM850 and GSM900. A second frequency band RF signal (Rfin_HB) is an RF transmission signal for DCS1800 and PCS1900 (refer to FIG. 23).

In an RF module according to the most specific embodiment, each of the first directional coupler and the second directional coupler is composed of a microcoupler having a capacitive element connected between the main line and the sub line thereof.

### <Description of the embodiments>

Hereinafter, embodiments of the invention will be further described in detail. In the embodiments described below, the invention will be described in a plurality of sections or embodiments when required as a matter of convenience. However, these sections or embodiments are not irrelevant to each other unless otherwise stated, and the one relates to the entire or a part of the other as a modification example, details, or a supplementary explanation thereof. Also, in the embodiments described below, when referring to the number of elements (including number of pieces, values, amount, range, and the like), the number of the elements is not limited to a specific number unless otherwise stated or except the case where the number is apparently limited to a specific number in principle. The number larger or smaller than the specified number is also applicable.

Further, in the embodiments described below, it goes without saying that the components (including element steps) are not always indispensable unless otherwise stated or except the case where the components are apparently indispensable in principle. Similarly, in the embodiments described below, when the shape of the components, positional relation thereof, and the like are mentioned, the substantially approximate and similar shapes and the like are included therein unless otherwise stated or except the case where it can be conceived that they are apparently excluded in principle. The same goes for the numerical value and the range described above.

Hereinafter, embodiments of the present invention will be described in detail with reference to the accompanying drawings. Note that components having the same function are denoted by the same reference symbols throughout the drawings for describing the embodiment, and the repetitive description thereof will be omitted. Further, in the following description, a configuration and an operation of a resonant circuit and an RF module including the resonant circuit will be described as an example of an electronic device according to an embodiment of the present invention.

### (First Embodiment)

FIG. 1 is a block diagram showing an example of the configuration of an RF module according to a first embodiment of the invention. An RF module (radio frequency power amplifying module) of the first embodiment is used in, for example, a mobile communication device such as a cellular telephone and is designed to support both of a low frequency band and a high frequency band. For example, the low band includes GSM (Global System for Mobile Communication) 850 or GSM 900 or the like, and the high band includes GSM 1800 or GSM 1900. Here, GSM means a standard of a wireless communication protocol used in the digital mobile phones. GSM includes four available radio wave frequency bands, and a band of 900 MHz (880 to 960 MHz) is referred to as GSM900 or simply as GSM. Also, a band of 1800 MHz (1710 to 1880 MHz) is referred to as GSM1800, DCS1800 or PCN. Also, a band of 1900 MHz (1850 to 1990 MHz) is referred to as GSM1900, DCS1900, or PCS (Personal Communication Services). GSM1900 is used mainly in the North America. In addition, in the North America, GSM850 corresponding to the band of 850 MHz (824-894 MHz) is also used.

An RF module RF_MDL shown in FIG. 1 is achieved by a single multilayer wiring substrate, and a semiconductor chip PA_CP in which a power amplifier circuit (power amplification circuit, radio frequency power amplifier circuit) and the like are formed and a semiconductor chip in which an antenna switch circuit ANT_SW is formed are mounted on the multilayer wiring substrate. Also, in RF_MDL, output matching circuits MN_LB and MN_HB, coupler circuits (directional coupler) CPL_LB and CPL_HB, and various filter circuits LPF_LB, LPF_HB, ANT_FIL, ESD_FIL, RX_FIL1 and RX_FIL2 are formed utilizing SMD (Surface Mount Device) components and wiring patterns of the multilayer wiring substrate.

The semiconductor chip PA_CP includes power amplifier circuits PA_LB and PA_HB and a control circuit CTL. PA_LB amplifies low-band signals such as GSM850 and GSM900 inputted to an external input terminal Pin_LB via a modulation circuit or the like (not shown). The amplified signal is transmitted to a terminal P1 of the antenna switch circuit ANT_SW via the output matching circuit MN_LB, the coupler circuit CPL_LB and the low-pass filter circuit LPF_LB in order. MN_LB is a circuit that performs impedance matching to, for example, characteristic impedance 50 Ω. CPL_LB is a circuit that detects an output power value of PA_LB via MN_LB and outputs the detection signal DS_LB to the control circuit CTL in PA_CP. The low-pass filter circuit LPF_LB is a circuit that attenuates harmonic signals (for example, second harmonic (2HD), third harmonic (3HD) or the like) contained in the output signal of PA_LB via CPL_LB. LPF_LB may be a band pass filter (BPF) through which a specific band is transmitted or a band elimination filter (BEF) that attenuates a specific band.

On the other hand, PA_HB amplifies high band signals such as GSM1800 and GSM1900 inputted to an external input terminal Pin_HB via a modulation circuit or the like (not shown). The amplified signal is transmitted to a terminal P2 of ANT_SW via the output matching circuit MN_HB, the coupler circuit CPL_HB and the low-pass filter circuit LPF_HB (or BPF or BEF) in order. MN_HB is a circuit that performs impedance matching to, for example, characteristic impedance 50 Ω or the like, and CPL_HB is a circuit that detects an output power value of PA_HB via MN_HB and outputs the detection signal DS_HB to the CTL in the PA_CP. LPF_HB is a circuit that attenuates harmonic (for example, second harmonic (2HD), third harmonic (3HD) or the like) contained in the output signal of PA_HB via CPL_HB.

The control circuit CTL in the semiconductor chip PA_CP receives a control signal from a base band circuit (not shown) to an external control input terminal CS1 and the above-described detection signals DS_LB and DS_HB to control PA_LB, PA_HB and ANT_SW. The control signal from the base band circuit includes, for example, a designation signal of the output power level to PA_LB and PA_HB which is generated based on the distance between a mobile phone and a base station, a switching signal to ANT_SW which is generated based on the contents of transmission/reception process, and the like. CTL controls the gain of PA_LB and PA_HB based on the designation signal of the output power level and the detection signals DS_LB or DS_HB, and it controls ANT_SW based on the switching signal.

ANT_SW is a circuit that connects any one of the terminals P1 to P4 to an antenna terminal P0 in response to the control signal from CTL described above. The antenna terminal P0 is connected to an external antenna terminal ANT via an antenna filter circuit ANT_FIL and an ESD filter circuit ESD_FIL, and an antenna (not shown) is connected to the ANT. ANT_FIL mainly attenuates harmonics generated at ANT_SW and contained in the received signal from the antenna. ESD_FIL mainly removes a band (for example, 400 MHz or 500 MHz band), which is harmful to ESD (electro static discharge), from the signal received from the antenna.

The terminal P3 of ANT_SW is connected to an external output terminal RX_LB via a reception filter circuit RX_FIL1, and the terminal P4 of ANT_SW is connected to an external output terminal RX_HB via a reception filter circuit RX_FIL2. Low band signals received via the antenna are transmitted to RX_LB, and high band signals received via the antenna are transmitted to RX_HB. These signals are then outputted to a demodulation circuit or the like (not shown). RX_FIL1 attenuates harmonic in the low band signals received from the antenna, and RX_FIL2 attenuates harmonic in the high band signals received from the antenna.

The RF module supporting plural bands as described above becomes larger in size than an RF module supporting a single band. Therefore, in addition to the size of the semiconductor chip, various filter circuits are required to be formed in a smaller area or at a lower cost. Here, for the reduction of the size of the multilayer wiring substrate (thickness reduction) and the cost thereof, for example, a commonly-used ceramic substrate having a stacked structure of four or five layers is preferably employed. In such a case, an emphasis is placed on how much the size of the various filter circuits (LPF_LB, LPF_HB, ANT_FIL, ESD_FIL, RX-FILL, RX_FIL2) and the output matching circuits (MN_LB and MN_HB) shown in FIG. 1 can be reduced in the four or five layers. Parallel resonant circuits composed of inductors and capacitors are included in the various filters and the output matching circuits in FIG. 1 in many cases. If such a parallel resonant circuit can be downsized without using SMD components, the size of the RF module or the cost thereof can be efficiently reduced.

Such a parallel resonant circuit can be realized with, for example, a configuration shown in FIG. 2A and FIG. 2B. FIG. 2A and FIG. 2B show an example of a configuration in a resonant circuit according to the first embodiment of the present invention. FIG. 2A is a perspective view of the resonant circuit, and FIG. 2B shows plan views illustrating the respective layers in FIG. 2A. The resonant circuit shown in FIG. 2A and FIG. 2B is achieved by using, for example, a four-layered multilayer wiring substrate including a first wiring layer LY1 and its underlying second wiring layer LY2, third wiring layer LY3 and fourth wiring layer LY4. The rear surface of LY4 is a ground electrode.

Wiring patterns MS21 to MS24 each of which is formed from an approximately loop-shaped line are formed in LY1 to LY4. One end of MS21 is a signal input node Nin and the other end thereof is connected to MS23 via the via hole conductor VH13a formed at a central portion of its own loop. One end of MS23 is connected to MS21 via the via hole conductor VH13a formed at a central portion of its own loop, and the other end thereof is connected to MS24 via the via hole conductor VH34a formed at a corner of its own loop.

One end of MS24 is connected to MS23 via the via hole conductor VH34a formed at a corner of its own loop, and the other end thereof is connected to MS22 via the via hole conductor VH24a formed beside its own loop. One end of MS22 is connected to MS24 via the via hole conductor VH24a formed beside its own loop, and the other end thereof is a signal output node Nout. Therefore, when a signal is transmitted from Nin to Nout, the signal is transmitted in each of the wiring patterns MS21 to MS24 through a loop in an anticlockwise direction, and thus MS21 to MS24 function as an inductor. Note that the Nin and the Nout may be arranged reversely. Further, in order to elongate the line length to increase the inductance value, each of the lines of MS23 and MS24 has partially curved portions.

The entire structure shown in FIG. 2A and FIG. 2B functions equivalently as a parallel resonant circuit LC1 including an inductor (coil) Lml and a capacitor (capacitance) Cml. Also, major characteristics of the parallel resonant circuit LC1 lie in the following points. First, by the extension of the wirings, the capacitive element between the signal input node Nin and the signal output node Nout is increased. FIG. 3A is a schematic equivalent circuit diagram of the parallel resonant circuit LC1 shown in FIG. 2A and FIG. 2B. FIG. 3B is a schematic equivalent circuit diagram of a spiral inductor Lc1 as a comparative example shown in FIG. 8 of the Patent Document 1.

In the parallel resonant circuit LC1 shown in FIG. 3A, the signal input node Nin of the first wiring layer LY1 is connected to the signal output node Nout via the inductor L1 of LY1, the inductor L3 of the third wiring layer LY3, the inductor L4 of the fourth wiring layer LY4 and the inductor L2 of the second wiring layer LY2 in order. L1 to L4 correspond to the wiring patterns MS21 to MS24 in FIG. 2A and FIG. 2B, respectively. Also, the capacitor C1 to be an interlayer capacitance between LY1 and LY2 is connected between Nin and Nout, and capacitors C2, C3 and C4 to be interlayer capacitances are connected between LY2 and LY3, between LY3 and LY4, and between LY4 and the rear surface, respectively.

On the other hand, in the spiral inductor Lc1 shown in FIG. 3B, Nin of LY1 is connected to Nout via the inductor L11 of LY1, the inductor L12 of LY2, the inductor L13 of LY3 and the inductor L14 of the LY4 in order. Also, the capacitors C11, C12, C13 and C14 to be the interlayer capacitances are connected between LY1 and LY2, between LY2 and LY3, between LY3 and LY4, and between LY4 and the rear surface, respectively. It should be noted that, in FIG. 3A and FIG. 3B, to be exact, an inductor or a resistor accompanied by the via hole conductor is inserted at, for example, the contact point N1 of L3 and L4 or the like in FIG. 3A, and also a capacitor accompanied by the interlayer capacitance of LY3 and LY4 is inserted in parallel thereto. However, the via hole conductor is simply illustrated as the wiring, and consequently, capacitors are also omitted. The same is true of the positions where the other via hole conductors are present in FIG. 3A and FIG. 3B.

As is understood from the equivalent circuit, in the structure of FIG. 3A, since Nin and Nout are formed on the layers adjacent to each other, the capacitive coupling (i.e. corresponding to capacitor C1) therebetween is performed efficiently. In addition, since the wirings are extended, all the inductance elements of LY1 to LY4 contribute as an inductance element between Nin and Nout. On the other hand, in the structure of FIG. 3B, the contribution of the inductance element is the same as that of the structure of FIG. 3A, but since the capacitive coupling between Nin and Nout is performed via plural capacitors connected in series (for example, C11 and C13), the capacitive coupling between Nin and Nout is weak. Therefore, by employing the extension of the wirings as shown in FIG. 3A, the capacitance value between Nin and Nout can be increased compared to the case of FIG. 3B, and thus, a downsized or low-cost resonant circuit can be realized.

Second, the line width of MS21 and MS22 is substantially the same, and the line width of MS23 and MS24 is also substantially the same. However, the maximum line width of MS21 and MS22 is formed to be larger than that of MS23 and MS24. By this means, the inductance element can be formed across MS21 to MS24, and the capacitance value between Nin and Nout can be further increased by MS21 and the MS22 which are formed opposed to each other via a layer.

Third, by disposing MS21 and MS22 in the layers (LY1 and LY2) separated away from the ground electrode on the rear surface of LY4, a larger inductance value can be obtained compared to the case where MS21 and MS22 are formed in LY3 and LY4. Generally, since the inductance of the wiring pattern formed on the grounding surface decreases due to the influence of image current generated by the grounding surface, the inductance can be increased by setting the larger distance of the wiring pattern from the grounding surface. Accordingly, by employing such a configuration as described above, the inductance value per unit area can be maximized. Therefore, the area necessary for obtaining a desired inductance value can be minimized, and thus the size of the resonant circuit can be reduced. Depending on the balance of the inductance values of MS21 to MS24, there may be the case where, by disposing MS23 and MS24 in the layers (LY1 and LY2) separated away from the ground electrode on the rear surface of LY4 to maximize the inductance value by MS23 and MS24, the resonant frequency of the resonant circuit can be reduced more efficiently or the area can be reduced without changing the resonant frequency. Therefore, it is preferable in such a case that the order of the layers in which MS21 to MS24 are disposed is changed to the order reverse to that shown in FIG. 2A and FIG. 2B.

Fourth, the wiring patterns MS21 to MS24 in FIG. 2A and FIG. 2B are formed so that the projection area thereof when viewed from the top is small. In other words, when the occupied areas of the respective wiring patterns of MS21 to MS24 are projected from the front surface side, the relationship that the occupied area of any one of the wiring patterns includes the occupied areas of the other wiring patterns is attained. FIG. 4 is a perspective view showing a configuration example of the major parts of the resonant circuit shown in FIG. 2A and FIG. 2B viewed transparently.

As shown in FIG. 4, the substantial occupied areas of MS21 to MS24 are AA21 to AA24, respectively. Then, when AA21 to AA24 are projected and viewed from the front surface side, the relationship that AA21 includes AA22 to AA24 is attained. In this case, each of the occupied areas of the AA21 to AA24 is equal to each other, and the entire area of AA22 to AA24 is included in the entire area of A21. The size of the occupied area (i.e., projection area) (A21 × A22) is not particularly restricted, but for example, the size may be about 1 mm × 1 mm. In this manner, for example, compared to the case where the respective wiring patterns are formed so as to be displaced from each other as shown in the Patent Document 3 (described later in FIG. 7B), the parallel resonant circuit can be realized in a smaller area.

Note that an example of the configuration where a four layered substrate is used in order to reduce the cost of the multilayer substrate has been described here. However, the number of layers of the substrate and the layout of the wires using via hole conductors can be variously changed within a technical scope of the present invention. For example, by changing the configuration in FIG. 2A and FIG. 2B, the wires can be laid from the first wiring layer to the fourth wiring layer, the third wiring layer and the second wiring layer in order. Also, in the case where a three layered substrate is employed, it is preferable that a wiring pattern having a thick line width like MS1 is formed in the first wiring layer and the second wiring layer and a wiring pattern having a thin line width like MS3 is formed in the third wiring layer, and then, the one end of the wiring pattern of the third wiring layer is connected to the first wiring layer and the other end thereof is connected to the second wiring layer.

Further, in the case where a five layered substrate is employed, for example, it is preferable that a wiring pattern having a thick line width like MS1 is formed in the first wiring layer and the second wiring layer, and a wiring pattern having a thin line width like MS3 is formed so as to have a spiral shape in the third to fifth wiring layers, and then, the one end of the wiring pattern of the third wiring layer is connected to the first wiring layer and the one end of the fifth wiring layer is connected to the second wiring layer. If there is no problem in the cost of the multilayer wiring substrate, the configuration as described above can be applied also to a multilayer wiring substrate with six or more layers.

As described above, according to the first embodiment, downsizing or cost reduction of the resonant circuit and the RF module including the same can be achieved.

### (Second Embodiment)

In the second embodiment, an example of a configuration of a resonant circuit, which is used in the various filter circuits and the output matching circuits shown in FIG. 1 but is different from the that shown in FIG. 2A and FIG. 2B, will be described. FIG. 5 shows an example of the configuration of a resonant circuit according to the second embodiment of the present invention, in which FIG. 5A is a perspective view of the resonant circuit and FIG. 5B is a plan view illustrating the respective layers shown in FIG. 5A. Similar to that shown in FIG. 2A and FIG. 2B, the resonant circuit shown in FIG. 5A and FIG. 5B is achieved by using, for example, a four layered multilayer wiring substrate including a first wiring layer LY1 to a fourth wiring layer LY4, and the rear surface of LY4 serves as a ground electrode.

Wiring patterns MS31 and MS32 each of which is formed from an approximately loop-shaped line are formed in LY1 and LY2. Wiring patterns (electrode pattern) MS33 and MS34 each of which is formed from a plane-shaped line are formed in LY3 and LY4. One end of MS31 is a signal input node Nin, and the signal input node Nin is connected to MS33 via a via hole conductor VH13b formed at a central portion of its own loop. On the other hand, the other end of MS31 is connected to MS32 via a via hole conductor VH12b formed at a corner of its own loop.

One end of MS32 is connected to MS31 via a via hole conductor VH12b formed at a corner of its own loop, and the other end thereof is a signal output node Nout and is connected to MS34 via the via hole conductor VH24b formed at another corner of its own loop. Further, MS33 and MS34 are formed so as to oppose to each other via a layer. Therefore, when a signal is transmitted from Nin to Nout, the signal is transmitted through an anticlockwise loop in MS31 and MS32, and thus MS31 and MS32 function as an inductor. In addition, a capacitance is formed at Nin and Nout by MS33 and MS34, respectively. Therefore, the entire configuration example in FIG. 5 functions equivalently as a parallel resonant circuit LC2 including the inductor Lm2 and the capacitor Crn2 as a whole. Note that Nin and Nout may be arranged reversely.

FIG. 6 is a simple equivalent circuit diagram of the parallel resonant circuit LC2 in FIG. 5A and FIG. 5B. In FIG. 6, Nin of LY1 is connected to Nout via the inductor L5 of LY1 and the inductor L6 of LY2 in order. L5 and L6 correspond to the wiring pattern MS31 and MS32 in FIG. 5, respectively. Also, the capacitor C7 corresponding to MS33 of LY3 and MS34 of LY4 shown in FIG. 5 is connected between Nin and Nout, and capacitors C5, C6 and C8 to be an interlayer capacitance are connected between LY1 and LY2, between LY2 and LY3 and between LY4 and the rear surface, respectively. Similar to the above-described equivalent circuit in FIG. 3, the illustration of the via hole conductors and the like is omitted.

Major characteristics of the parallel resonant circuit having the configuration as described above according to the second embodiment lie in the following points. First, similar to the first embodiment, since Nin and Nout are formed in the layers adjacent to each other, the capacitance value (corresponding to C5 in FIG. 6) is increased. In addition, the capacitance value (corresponding to C7 connected in parallel to C5 in FIG. 6) is increased by MS33 and MS34. Second and third, as described in the first embodiment, the inductors (MS31 and MS32) are disposed in the layers separated away from the grounding surface, and the wiring layers are arranged so that the wiring patterns have the small projection area.

The projection area mentioned as the third point will be described with reference to FIG. 7A and FIG. 7B. FIG. 7A is a perspective view illustrating an example of the configuration of the major parts shown in FIG. 5. FIG. 7B is a perspective view showing a comparative configuration thereof. The resonant circuit LCc2 shown in FIG. 7B as a comparative example reflects the example of the configuration disclosed in the above-described Patent Document 3. Substantial occupied areas of MS31 to MS34 shown in FIG. 5 are denoted by AA31 to AA34, respectively, as shown in FIG. 7A. When the occupied areas AA31 to AA34 are projected from the front surface side thereof, the relationship that occupied area AA31 includes occupied areas AA32 to AA34 is attained. The size of the occupied area (i.e., projection area) (A31 × A32) is not particularly limited, but it may be, for example, about 1 mm × 1 mm.

On the other hand, in the comparative example, substantial occupied areas of the inductor patterns are denoted by AA41 and AA42, and substantial occupied area of the capacitor patterns are denoted by AA43 and AA44 as shown in FIG. 7B. Therefore, when the occupied areas AA41 to AA44 are viewed in projection from the front surface side thereof, the relationship that the occupied area AA41 does not include the occupied area AA43 is attained. Although the projection area is increased in this case, downsizing of the parallel resonant circuit can be achieved if the configuration as shown in FIG. 7A (FIG. 5) is employed.

Incidentally, as a comparison between the configuration example in FIG. 2A and FIG. 2B and the configuration example in FIG. 5A and FIG. 5B, when the respective examples are formed to have the same area and the same number of layers, since the inductance element is achieved by the two layers of MS31 and MS32 in the configuration example in FIG. 5A and FIG. 5B, the inductance value is smaller than that of the configuration example in FIG. 2A and FIG. 2B. Further, since MS33 and MS34 are formed in a narrow projection area of AA33 and AA34, the capacitance value is also reduced. Therefore, the resonant frequency by the configuration example in FIG. 5A and FIG. 5B is larger than the resonant frequency by the configuration example in FIG. 2A and FIG. 2B. Accordingly, the configuration example in FIG. 5A and FIG. 5B is preferably applied to, for example, a filter circuit or the like which supports the high band shown in FIG. 1.

Similar to the case of the configuration example in FIG. 2A and FIG. 2B, the number of substrate layers and the layout using via hole conductors can be variously changed also in the configuration example in FIG. 5A and FIG. 5B within a technical scope of the present invention. For example, when a five layered substrate is employed, a wiring pattern such as that of MS31 is formed spirally from the first wiring layer to the third wiring layer and the second wiring layer in order, and a wiring pattern of a plane shape such as that of MS33 is formed by the fourth wiring layer and the fifth wiring layer. Then, one end of the wiring pattern of the first wiring layer is connected to the fourth wiring layer, and one end of the wiring pattern of the second wiring layer is connected to the fifth wiring layer. In the case of the configuration example in FIG. 5A and FIG. 5B, regardless of the number of substrate layers, by disposing the wiring pattern constituting the inductor in a layer separated away from the ground electrode relative to the plane-shaped wiring pattern constituting the capacitance, the inductance value per unit area can be maximized, the area required for obtaining a desired inductance value can be minimized, and thus the downsizing of the resonant circuit is achieved.

As described above, according to the second embodiment, downsizing or cost reduction of the resonant circuit and the RF module including the same can be achieved.

### (Third Embodiment)

In the third embodiment, a configuration example in the case where the parallel resonant circuit LC1 in FIG. 2A and FIG. 2B and the parallel resonant circuit LC2 in FIG. 5A and FIG. 5B are applied to the RF module in FIG. 1 will be described in detail. FIG. 8 is a circuit diagram showing an example of a configuration in an RF module according to the third embodiment of the present invention. In the RF module shown in FIG. 8, as described in FIG. 1, an output from the power amplifier circuit PA_LB for low band is transmitted to the antenna switch circuit ANT_SW via the output matching circuit MN_LB, the coupler circuit CPL_LB, the low-pass filter circuit LPF_LB and the capacitor Cs13. Here, the output of PA_LB formed in a semiconductor chip is connected to MN_LB formed on the wiring substrate via a bonding wire or the like. Further, Cs13 is a capacitor for cutting direct current and is formed from, for example, SMD components.

PA_LB is, for example, an amplifier circuit having a three-stage structure including three power transistors in master-slave connection. MN_LB is a matching circuit of a three-stage low-pass filter including, for example, transmission lines LN1 to LN3 and capacitors Cs1 to Cs3 disposed between the respective outputs of the lines LN1 to LN3 and the ground voltage GND. Cs1 to Cs3 are, for example, SMD components. LN1 to LN3 are connected in series from the output side of PA_LB in order. One end of Cs1 is connected to the output of LN1, and the other end thereof is connected to GND via the inductor Li1. Similarly, one ends of Cs2 and Cs3 are connected to LN2 and LN3, and the other ends thereof are connected to GND via the inductors Li2 and Li3. Li1 to Li3 are parasitic inductors corresponding to, for example, via hole conductors or the like.

CPL_LB includes a main line and a sub line each formed to be electromagnetically coupled. One end of the main line is connected to the output of LN3, and the other end thereof is connected to LPF_LB. One end of the sub line is connected to a terminating resistor (for example, 50 Ω), and the other end thereof is connected to a power detection circuit DET_LB formed on the same semiconductor chip as PA_LB via a bonding wire or the like.

LPF_LB is constituted of a parallel resonant circuit disposed between one end of the main line of CPL_LB and one end of the capacitor Cs13 and two serial resonant circuits connected between the both ends of the parallel resonant circuit and GND. The parallel resonant circuit includes an inductor Li9 and a capacitor Cs9. One of the serial resonant circuits includes a capacitor Cs8 and an inductor Li8 connected from one end of the main line of CPL_LB in order, and the other of the serial resonant circuits includes a capacitor Cs10 and an inductor Li10 connected from one end of Cs13 in order. Cs8 to Cs10 are formed from, for example, SMD components, and Li8 to Li10 are formed from internal circuits of a wiring substrate (via hole conductors and transmission lines). LPF_LB attenuates, for example, second harmonic (2HD), third harmonic (3HD) and seventh harmonic (7HD) contained in the low band signal outputted from PA_LB.

On the other hand, similar to the low band side configuration, on the high band side, an output from a power amplifier circuit PA_HB for high band is transmitted to an antenna switch circuit ANT-SW via an output matching circuit MN_HB, a coupler circuit CPL_HB, a low-pass filter circuit LPF_HB and a capacitor Cs14. Here, the output of PA_HB is connected to MN_HB via a bonding wire or the like. Further, Cs14 is a capacitor for cutting direct current and is formed from, for example, SMD components.

Similar to PA_LB, PA_HB is an amplifier circuit having a three-stage structure including three power transistors in master-slave connection. MN_LB is a matching circuit of a four-stage low-pass filter including, for example, transmission lines LN4 to LN7 and capacitors Cs4 to Cs7 disposed between the respective outputs of LN4 to LN7 and GND. Cs4 to Cs7 are, for example, SMD components. LN4 to LN7 are connected in series from the output side of PA_HB in order. One end of Cs4 is connected to the output of LN4, and the other end thereof is connected to GND via the inductor Li4. Similarly, one ends of Cs5, Cs6 and Cs7 are connected to LN5, LN6 and LN7, and the other ends thereof are connected to GND via the inductors Li5, Li6 and Li7. Li4 to Li7 are parasitic inductors corresponding to, for example, via hole conductors or the like.

CPL_HB includes a main line and a sub line each formed to be electromagnetically coupled. One end of the main line is connected to the output of LN7, and the other end thereof is connected to LPF_HB. One end of the sub line is connected to a terminating resistor (for example, 50 Ω), and the other end thereof is connected to a power detection circuit DET_HB formed on the same semiconductor chip as PA_HB (and PA_LB) via a bonding wire or the like.

LPF_HB is constituted of a parallel resonant circuit disposed between one end of the main line of CPL_HB and one end of the capacitor Cs14 and a serial resonant circuit connected between the one end (Cs 14 side) of the parallel resonant circuit and GND. The parallel resonant circuit includes an inductor Li11 and a capacitor Cs11. The serial resonant circuit includes a capacitor Cs12 and an inductor Li12 connected from one end of Cs14 in order. Cs11 and Cs12 are formed from, for example, SMD components, and Li11 and Li12 are formed from internal circuits of the wiring substrate. LPF_HB attenuates, for example, second harmonic (2HD) and third harmonic (3HD) contained in the high band signal outputted from PA_HB.

An antenna terminal P0 of the antenna switch circuit ANT_SW is connected to an external antenna terminal ANT via an antenna filter circuit ANT_FIL, an ESD filter circuit ESD_FIL and a capacitor Cs16 in order. Cs16 (here, 8.2 pF) is a capacitor for cutting direct current, and is formed from, for example, SMD components. Also, an inductor Ls for adjusting the impedance formed from, for example, SMD components (here, 15 nH) is connected between ANT and GND.

ANT_FIL includes a parallel resonant circuit connected between P0 and one end of Cs16 and a capacitor Cs15 for impedance adjustment connected between P0 and GND. Cs15 (here, 0.5 pF) is formed from, for example, SMD components. On the other hand, the parallel resonant circuit includes an inductor Li13 and a capacitor Ci1, and the parallel resonant circuit LC2 of the second embodiment shown in FIG. 5 is used therein. The parallel resonant circuit is achieved in a circuit area of 1 mm × 1 mm, the inductance value of Lil3 is, for example, 3.5 nH, and the capacitance value of Ci1 is, for example, 0.25 pF. By this means, signals of about 5.4 GHz to be a third harmonic (3HD) contained in the high band signal are attenuated. ANT_FIL mainly attenuates 3HD contained in the high band signal generated when passing through ANT_SW and 3HD contained in the high band signal received from the antenna.

ESD_FIL includes a capacitor Cs15 and an inductor Li14 connected in series from one end of Cs16 to GND. Cs15 is formed from, for example, SMD components and has a capacitance value of 13 pF. Li14 is formed from the internal circuit on the wiring substrate and has an inductance value of 12 nH. ESD_FIL mainly attenuates signals of about 400 MHz, which are harmful to ESD, contained in the received signals from the antenna.

The terminal P3 of ANT_SW is connected to the external output terminal RX_LB via a capacitor Cs17 for cutting direct current and a reception filter circuit RX_FIL1 in order. Cs17 (here, 7.4 pF) is formed from, for example, SMD components.

RX_FIL1 is connected between one end of Cs17 and RX_LB, and includes a parallel resonant circuit constituted of an inductor Li15 and a capacitor Ci2. Here, the parallel resonant circuit LC1 of the first embodiment shown in FIG. 2A and FIG. 2B is used for the parallel resonant circuit. The parallel resonant circuit is achieved in a circuit area of 1 mm × 1 mm, the inductance value of Li15 is, for example, 5.6 nH, and the capacitance value of Ci2 is, for example, 0.6 pF. By this means, signals of about 2.7 GHz to be the third harmonic (3HD) contained in the low band signal are attenuated. That is, RX_FIL1 attenuates 3HD contained in the low band signal received from the antenna.

The terminal P4 of ANT_SW is connected to an external output terminal RX_HB via a reception filter circuit RX_FIL2 and a capacitor Cs19 for cutting direct current in order. Cs19 (here, 8pF) is formed from, for example, SMD components. RX_FIL2 includes a capacitor Cs18 and an inductor Li16 connected in series from P4 to GND in order. Cs18 is formed from, for example, SMD components and has a capacitance value of 10 pF. Li16 is formed from the internal circuit of the wiring substrate and has an inductance value of 9 nH. Since 3HD contained in the high band signal is attenuated by ANT_FIL, different from RX_FIL1, RX_FIL2 includes a filter circuit for ESD. RX_FIL2 attenuates signals of about 400 MHz which are harmful to ESD.

As described above, the RF module shown in FIG. 8 uses the parallel resonant circuits LC1 shown in FIG. 2A and FIG. 2B and LC2 shown in FIG. 5A and FIG. 5B, which can be achieved in a small area without using SMD components, for attenuating the third harmonic (3HD) contained in the low band signal and high band signal. Accordingly, downsizing of the RF module or cost reduction can be realized. Although the constitution shown in FIG. 5A and FIG. 5B is used to handle the high band signal and the constitution shown in FIG. 2A and FIG. 2B which can generate resonant frequency lower than that of the constitution shown in FIG. 5A and FIG. 5B is used to handle the low band signal in this embodiment, any combination other than that can be used as long as the necessary circuit constant can be obtained.

Also, in this embodiment, the parallel resonant circuit LC1 shown in FIG. 2A and FIG. 2B and the parallel resonant circuit LC2 shown in FIG. 5A and FIG. 5B are used for attenuating the third harmonic (3HD). Needless to say, the parallel resonant circuits LC1 and LC2 can be used for attenuating the second harmonic (2HD) or n-th (n≥4) harmonic. That is, for example, in the example of the circuit shown in FIG. 8, the parallel resonant circuits LC1 and LC2 can be applied to LPF_LB and LPF_HB. The reason why the parallel resonant circuits LC1 and LC2 are applied only for attenuating the third harmonic (3HD) in the third embodiment is that the filter circuit for 3HD attenuation has a sufficient margin for characteristic variability caused from the manufacturing variation of the wiring substrate. In other words, when a manufacturing variation of the wiring substrate occurs actually, the influence has to be corrected using a parameter of SMD components in some cases. However, the parallel resonant circuits LC1 and LC2 have little need for such correction.

Also, the parallel resonant circuit LC1 shown in FIG. 2A and FIG. 2B corresponding to the inductor Li15 and the capacitor Ci2 shown in FIG. 8 can be represented by an equivalent circuit shown in FIG. 3A as described above. The parameter values of the respective circuit elements in this case are calculated. As a result, the values of L1, L2, L3 and L4 are about 0.8 nH, 0.8 nH, 2.0 nH and 2.0 nH by estimate. Further, the values of C1, C2, C3 and C4 are about 0.4 pF, 0.1 pF, 0.1 pF and 0.1 pF by estimate. As is apparent from above, MS21 and MS22 shown in FIG. 2A and FIG. 2B can realize sufficient inductance elements (L1 and L2) and a capacitive element (C1).

On the other hand, the parallel resonant circuit LC2 shown in FIG. 5A and 5B corresponding to the inductor Li13 and capacitor Ci1 shown in FIG. 8 can be represented by an equivalent circuit shown in FIG. 6 as described above. The parameter values of the respective circuit elements in this case are calculated. As a result, the values of L5 and L6 are about 1.7 nH and 1.7 nH by estimate. Further, the values of C5, C6, C7 and C8 are about 0.05 pF, 0.05 pF, 0.15 pF and 0.15 pF by estimate.

As described above, compared with the parallel resonant circuit LC1 shown in FIG. 2A and FIG. 2B, the parallel resonant circuit LC2 shown in FIG. 5A and FIG. 5B has a smaller inductance value and a smaller capacitance value. However, a sufficient constant for attenuating the harmonic can be achieved. Also, as is apparent from the equivalent circuit described above, the number of parameters (circuit elements) to be components elements in LC2 in FIG. 5A and FIG. 5B is smaller than that of LC1 in FIG. 2A and FIG. 2B. Therefore, it can be understood that the influence of the characteristic variation of the wiring substrate or the like is small.

As described above, according to the third embodiment, downsizing or cost reduction of the resonant circuit and the RF module including the same can be achieved.

### (Fourth Embodiment)

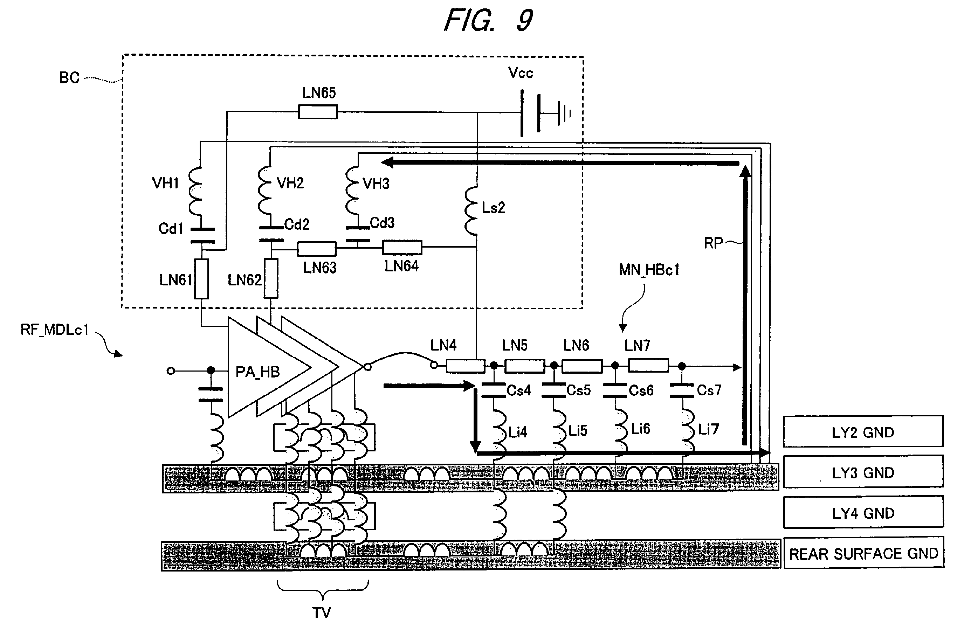

In the fourth embodiment, a method for solving a problem of return path which may occur when the RF module in FIG. 1 is miniaturized will be described. First, the problem of return path will be described with reference to FIG. 9. FIG. 9 is a circuit diagram showing a configuration example of a power amplifier circuit and the periphery thereof in an RF module examined as a premise of the present invention.

An RF module RF_MDLc1 shown in FIG. 9 is equivalent to a part of the power amplifier circuit PA_HB for high band signals and the output matching circuit MN_HB thereof extracted from an example of the circuit in FIG. 8 described in the third embodiment. Hereinafter, descriptions about a part overlapping with that in FIG. 8 will be omitted. As a configuration of a wiring substrate in the RF module RF_MDLc1 in FIG. 9, generally, a ground electrode pattern is formed in the respective wiring layers (LY2 to LY4) just below a semiconductor chip in which PA_HB is formed. By connecting these ground electrode patterns and ground electrodes on the rear surface via a via hole conductor, the most stable area for ground voltage GND is formed. The area is generally called as a formation area for a thermal via TV.

On the other hand, for example, in an output matching circuit MN_HBc1 connected to an output of PA_HB, an output power of PA_HB flows into a ground electrode pattern of LY3 via capacitors Cs4 to Cs7 (particularly, Cs4) and inductors Li4 to Li7 (particularly, Li4). The ground electrode pattern is connected to the formation area of a thermal via TV in LY3, and is further connected to the ground electrode of the rear surface via a via hole conductor. Also, Cs4 to Cs7 are mounted in, for example, the first wiring layer LY1 as SMD components, and Li4 to Li7 correspond to the via hole conductors connecting LY1 and LY3.

Incidentally, although not shown in the circuit example in FIG. 8, for example, a bias circuit BC show in FIG. 9 is connected to each of the output nodes of the three-stage power transistors in master-slave connection included in PA_HB. In BC, generally, a bias voltage Vcc is supplied to each of the outputs of the power transistors (i.e., input to the next stage) via an inductor for blocking radio frequency called as choke coil, and a radio frequency capacitor for grounding called as decoupling capacitor is provided between Vcc and the ground voltage GND. In FIG. 9, the choke coils correspond to transmission lines LN61 to LN65 and an inductor Ls2, and the decoupling capacitors correspond to capacitors Cd1 to Cd3.

Cd1 to Cd3 are mounted in LY1 as SMD components, one ends thereof are connected to Vcc and the other ends thereof are connected to a ground electrode pattern of LY3 via the via hole conductors (inductor) VH1 to VH3 connecting between LY1 and LY3. Therefore, as indicated with arrows in FIG. 9, a path is formed, through which an output current from PA_HB flows into the ground electrode pattern of LY3 via capacitive couplings (Cs4 to Cs7 (particularly, Cs4)), and further, it returns from the ground electrode pattern to the input of the power transistor via capacitive couplings (Cdl to Cd3). The path is called as return path RP.

In the example of the circuit shown in FIG. 9, the return path RP via the bias circuit BC has been described. In addition to this, though not shown, there is a return path via, for example, matching circuits inserted between the respective stages of the power transistors. More specifically, for example, an output of a power transistor on a first stage is once extended onto a wiring substrate via a bonding wire, and after performing impedance matching on the wiring substrate, the output is returned to the input of a power transistor on a second stage via a bonding wire again. In such a case, the matching circuit on the wiring substrate also may be the return path. The return path causes the oscillation phenomenon resulting in a malfunction as described above. Such a problem can be reduced if the distance between the output matching circuit MN_HBc1 and the bias circuit BC in FIG. 9 can be sufficiently ensured. However, the downsizing inversely becomes difficult in such a case.

For the achievement of both the downsizing and the solution of the problem of the return path, for example, the configuration shown in FIG. 10 is preferably employed. FIG. 10 is a circuit diagram showing a configuration example of the periphery of a power amplifier circuit in an RF module according to the fourth embodiment of the present invention. Compared to the configuration example in FIG. 9, the RF module RF_MDLa shown in FIG. 10 has characteristics that a wiring pattern MS72 connecting inductors (via hole conductor) Li4 and Li5 and a formation area of the thermal via TV is added in LY2, and further, a plurality of via hole conductors (inductor) VHm connecting MS72 and the ground electrode pattern of LY3 are added. For MS72, a line-shaped wiring pattern is used.

According to the configuration as described above, based on GND corresponding to TV formation area used as a reference, a contact potential VA between the via hole conductors Li4 and Li5 and MS72 becomes higher than a contact potential VB between Li4 and Li5 and the ground electrode pattern of LY3. Therefore, a large current flows in a direction from MS72 to TV in LY2. At this time, since the bias circuit BC is connected to the ground electrode pattern of LY3, the current flowing to LY2 does not flow directly. Also, though a small amount of current flows to the ground electrode pattern of LY3 via the via hole conductors Li4 and Li5, since the ground electrode pattern of LY3 is connected to MS72 via plural VHm, the current easily flows in a direction toward the TV formation area. Consequently, current hardly flows to the side of the bias circuit BC connected to the ground electrode pattern of LY3, and thus, the problem of return path can be solved. Furthermore, by connecting MS72 and the ground electrode pattern of LY3 via the plural VHm, the influence of the inductance element of MS72 can be reduced, and a problem that the characteristics of the output matching circuit MN become nonuniform can be prevented.

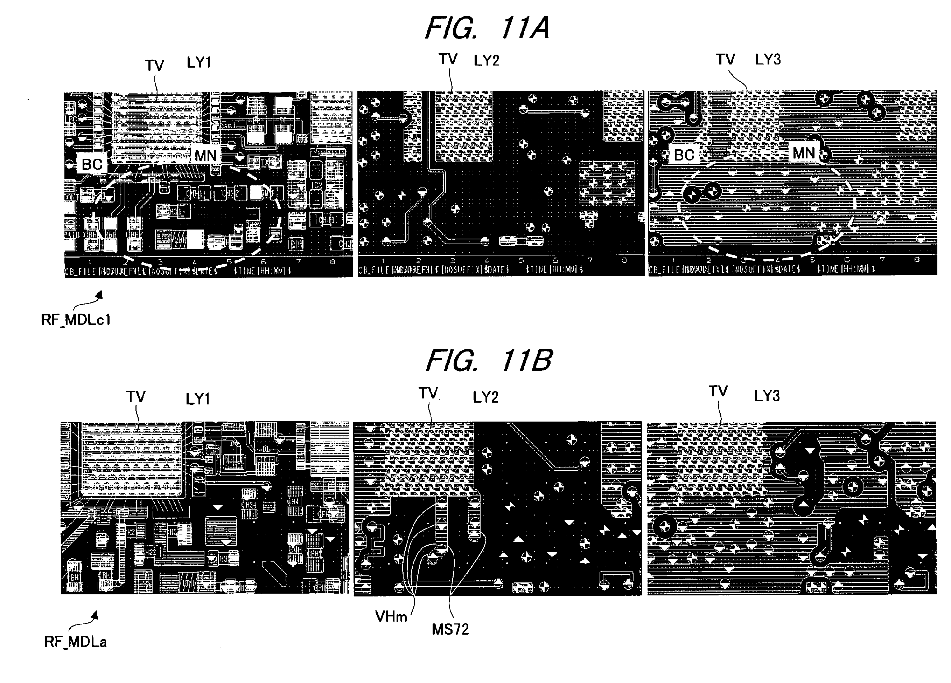

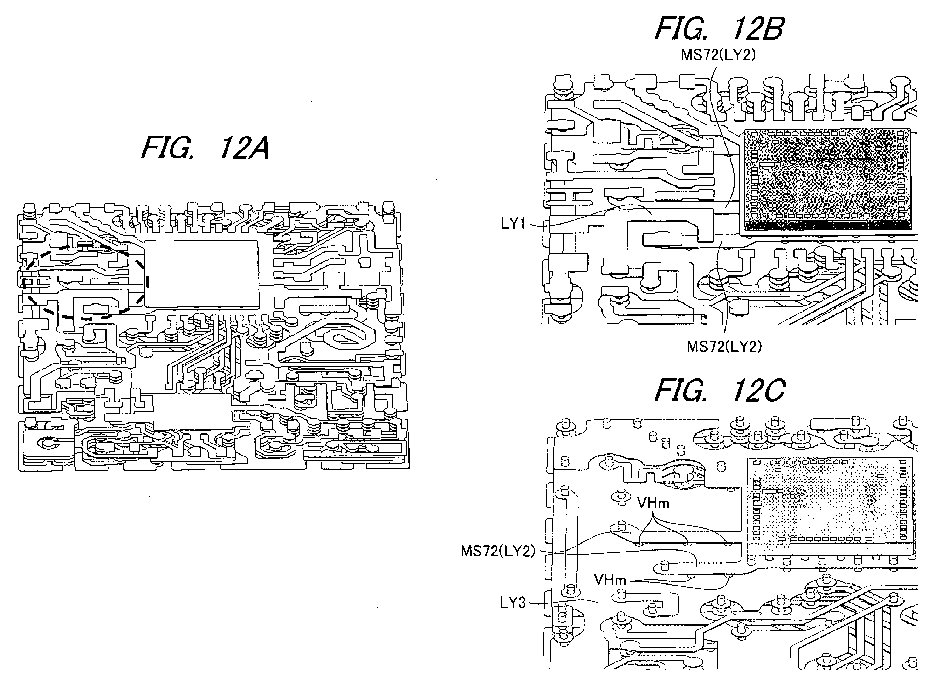

FIG. 11A and FIG. 11B show a configuration example of a wiring substrate of the periphery of a power amplifier circuit in an RF module according to the fourth embodiment of the present invention. FIG. 11A is a layout diagram corresponding to the configuration in FIG. 9 as a comparative example, and FIG. 11B is a layout diagram corresponding to the configuration in FIG. 10. FIG. 12A to FIG. 12C show a configuration example of a wiring substrate corresponding to the configuration in FIG. 10 in the RF module according to the fourth embodiment of the present invention. FIG. 12A is a perspective view of the entire wiring substrate viewed transparently, FIG. 12B is an enlarged perspective view of the periphery of the power amplifier circuit and FIG. 12C is a perspective view of FIG. 12B in which the first wiring layer is omitted.

FIG. 11A and FIG. 11B show parts of the layout pattern corresponding to the first wiring layer LY1, the second wiring layer LY2 and the third wiring layer LY3, respectively. As shown in FIG. 11A, the output matching circuit MN and the bias circuit BC are disposed at approximately the same position. In the configuration (comparative example) in FIG. 9, as shown FIG. 11A, no wiring pattern which connects MN to the formation area of the thermal via TV is present in LY2, and GND of MN via a via hole conductor is connected to GND of BC via the via hole conductor in the ground electrode pattern in LY3. On the other hand, in the configuration (present embodiment) shown in FIG. 10, as shown in FIG. 11B and FIG. 12A to FIG. 12C, a wiring pattern MS72 connected from MN to TV formation area is provided in LY2, and MS72 is connected to the ground electrode pattern of LY3 via plural via hole conductors VHm.

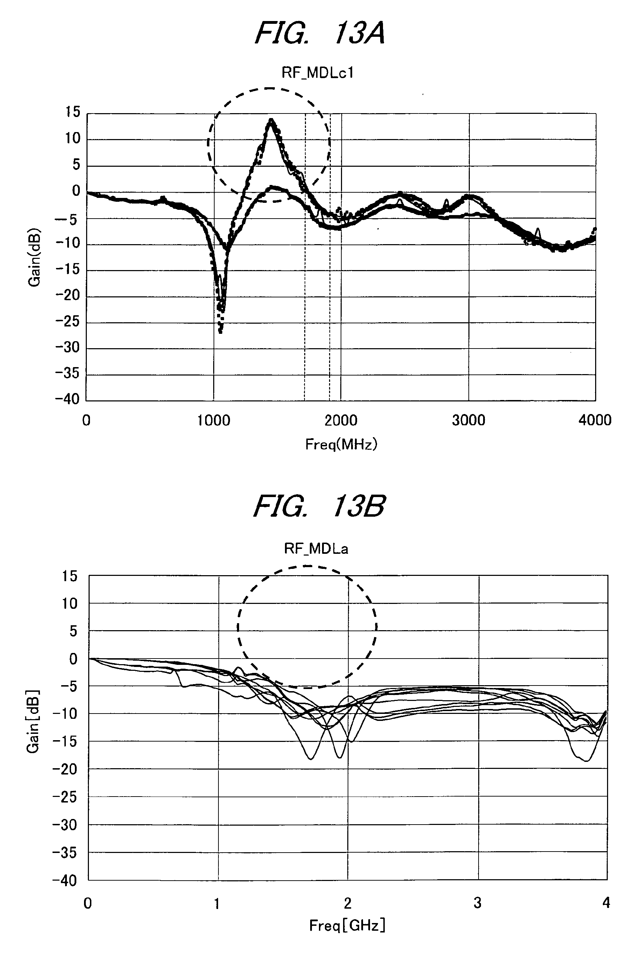

FIG. 13A and FIG. 13B show evaluation results of return gain values in the configuration (comparative example) in FIG. 9 and the configuration in FIG. 10. FIG. 13A is a graph showing the evaluation result of the configuration in FIG. 9, and FIG. 13B is a graph showing the evaluation result of the configuration in FIG. 10. As shown in FIG. 13A and FIG. 13B, in the RF module RF_MDLc1 in FIG. 9, a return gain of about 15 dB is found at about 1.5 GHz, and an oscillation phenomenon occurs due to the return gain. On the other hand, in the RF module RF_MDLa in FIG. 10, return gain exceeding 0 dB is not found over a wide band (0 to 4 GHz), and no oscillation phenomenon occurs.

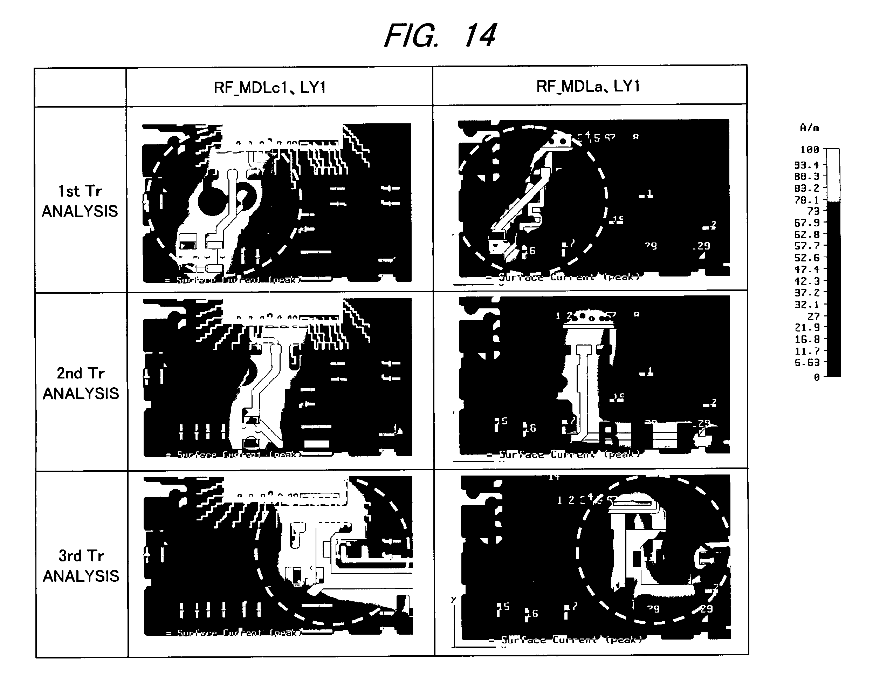

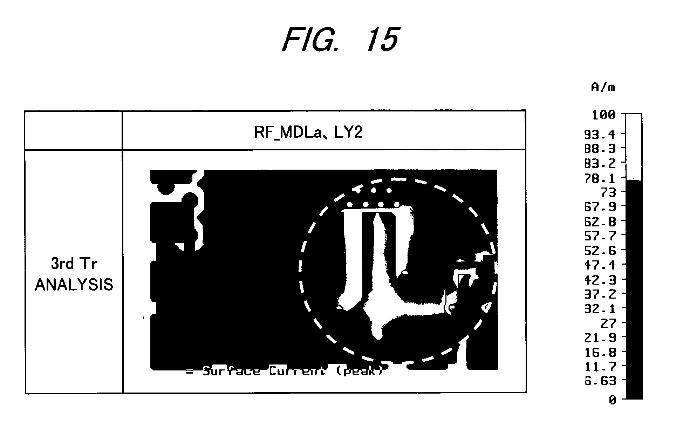

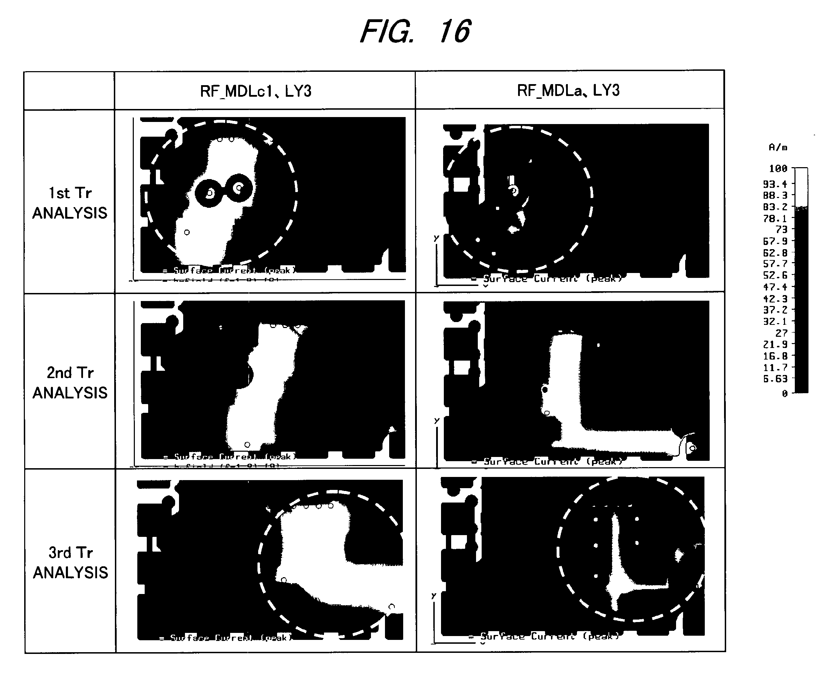

FIG. 14 to FIG. 16 show a result of current density analysis on the configuration (comparative example) in FIG. 9 and the configuration in FIG. 10. FIG. 14 shows a result of analysis on the first wiring layer LY1, FIG. 15 shows a result of analysis on the second wiring layer LY2, and FIG. 16 shows a result of analysis on the third wiring layer LY3. In FIG. 14 to FIG. 16, under the condition that a power is outputted from the power amplifier circuit PA in the third stage, a return current toward the input of the power transistor (Tr) on the first stage (1st), a return current toward the input of Tr on the second stage (2nd) and a return current toward the input of Tr on the third stage (3rd) are independently analyzed.

First, in the result of analysis of LY1 shown in FIG. 14, a result of the RF module RF_MDLc1 in FIG. 9 as the comparative example is shown on the left side, and a result of the RF module RF_MDLa in FIG. 10 according to the present embodiment is shown on the right side. As is apparent from FIG. 14, compared to the RF module RF_MDLc1 in FIG. 9, in the RF module RF_MDLa in FIG. 10, the return current to the 1st Tr and the return current to the 3rd Tr are largely reduced. Next, according to the result of analysis of LY2 shown in FIG. 15, in the RF module RF_MDLa in FIG. 10, a large amount of current flows toward the side of the TV formation area via the above-described wiring pattern MS72. It should be noted that, since such wiring pattern is not provided in the RF module RF_MDLc1 in FIG. 9, there is no result corresponding to that of FIG. 15.

Finally, in the result of the analysis of LY3 shown in FIG. 16, the result of the RF module RF_MDLc1 in FIG. 9 as the comparative example is shown on the left side, and the result of the RF module RF_MDLa in FIG. 10 according to the present embodiment is shown on the right side. As is apparent from FIG. 16, compared to the RF module RF to MDLc1 in FIG. 9, in the RF module RF_MDLa in FIG. 10, the return current to the 1st Tr and the return current to the 3rd Tr are largely reduced. It can be understood from the analysis described above that the return current toward the input can be largely reduced by using the RF module RF_MDLa in FIG. 10.

FIG. 17A and FIG. 17B are schematic diagrams illustrating the examples of preferred application of the configuration example in FIG. 10. FIG. 17A and FIG. 17B show different configuration examples. For example, as shown in the RF module RF_MDLc2 in FIG. 17B, there is a case where a third stage (final stage) in a three-stage power transistor (Tr) constituting a power amplifier circuit is formed and mounted in another semiconductor chip. More specifically, Tr on the first stage and that on the second stage corresponding to the low band and the high band are formed in a single semiconductor chip PA_CPc1, Tr on the third stage corresponding to the low band is formed in another semiconductor chip PA_CPc2, and Tr on the third stage corresponding to the high band is formed in still another semiconductor chip PA_CPc3.

In such a case, the three semiconductor chips PA_CPc1 to PA_CPc3 are mounted on RF_DLc2. Consequently, since the distance from the output of Tr on the third stage to the input of Tr on the first stage or second stage is increased, the problem of the return path described above can be easily solved. However, in such a configuration, the RF module RF_DLc2 becomes larger and the cost thereof is increased.

Therefore, for the achievement of the downsizing or the cost reduction, it is desired to form the three-stage Tr in the single semiconductor chip PA_CP like the RF module RF_MDL shown in FIG. 17A. However, in this case, the distance from the output of Tr on the third stage to the input Tr on the first stage or second stage is reduced, and thus, the problem of the return path remarkably arises. In such a case, by using the configuration example shown in FIG. 10, the problem of return path can be solved and downsizing or cost reduction of the RF module can be achieved.

As described above, according to the fourth embodiment, the problem of the return path can be suppressed, and thus, downsizing or cost reduction of the RF module can be achieved.

### (Fifth Embodiment)

### <RF module>

FIG. 19 is a diagram showing a circuit configuration of an RF module according to the fifth embodiment of the present invention. Basic difference between the RF module in FIG. 19 and the RF module in FIG. 18 is the connecting order of an output matching circuit 12c, a directional coupler (CPL) 13 and a harmonic elimination filter (LPF) 14.

Therefore, the RF module according to the fifth embodiment of the present invention in FIG. 19 has the following advantage. That is, it is assumed that a harmonic component of the output amplification signal Pout from the RF power amplifier HPA is transmitted to the signal line between the sub line of the directional coupler 13 and the gain control unit 17 and to the sub line and the main line of the directional coupler 13 in FIG. 19. Even in such a case, the harmonic elimination filter 14 is connected between the main line of the directional coupler 13 and the antenna 16. Therefore, it is possible to prevent the high level harmonic component from the output of the RF power amplifier HPA from being transmitted to the antenna 16 via the signal line between the sub line of the directional coupler 13 and the gain control unit 17 and the sub line and the main line of the directional coupler 13.

The RF module in FIG. 19 includes an RF power amplifier HPA, an output matching circuit 12c on the final stage, a directional coupler (CPL) 13, a harmonic elimination filter (LPF) 14 and an antenna switch (ANT_SW) 15. The antenna switch 15 is connected to the antenna (ANT) 16 of a mobile phone outside the RF module.

### <Monolithic semiconductor integrated circuit in RF module>

The RF power amplifier HPA is formed on a monolithic semiconductor integrated circuit chip, and includes an initial-stage amplifier 10a, an initial-stage bias circuit 10b, a first interstage matching circuit 10c, a second-stage amplifier 11a, a second-stage bias circuit 11b, a second interstage matching circuit 11c, a final-stage amplifier 12a, a final-stage bias circuit 12b and a gain control unit 17. An RF amplification signal RFin is supplied to an initial-stage RF input terminal of the initial-stage amplifier 10a, and an initial-stage RF amplification output signal of the initial-stage amplifier 10a is supplied to a second-stage RF input terminal of the second-stage amplifier 11a via the first interstage matching circuit 10c. The second-stage RF amplification output signal of the second-stage amplifier 11a is supplied to a final-stage RF input terminal of the final-stage amplifier 12a via the second interstage matching circuit 11c.

On a silicon chip of a monolithic semiconductor integrated circuit, power MOSFETs of LD (Lateral Diffused) MOS constituting the initial-stage amplifier 10a, the second-stage amplifier 11a and the final-stage amplifier 12a are formed. The first interstage matching circuit 10c reduces the signal reflection due to the difference between a relatively high output impedance of the initial-stage amplifier 10a and a relatively low output impedance of the second-stage amplifier 11a. The second interstage matching circuit 11c reduces the signal reflection due to the difference between the relatively low output impedance of the second-stage amplifier 11a and a still lower output impedance of the final-stage amplifier 12a. The first interstage matching circuit 10c and the second interstage matching circuit 11c are constituted of on-chip passive elements such as a spiral inductor and an MIM (metal/insulation film/metal) stacked capacitor formed on the silicon chip.

### <Discreet element in RF module>

The final-stage RF amplification output signal Pout from the final-stage amplifier 12a of the RF power amplifier HPA is connected to one end of the main line of the directional coupler (CPL) 13 via the final-stage output matching circuit 12c outside the monolithic semiconductor integrated circuit chip. The output matching circuit 12c reduces a signal reflection due to the difference between extremely low output impedance (about several Ω) from the final-stage amplifier 12a and a relatively high input impedance (about 50 Ω) from the directional coupler 13 and the antenna 16. The output matching circuit 12c is constituted of discreet passive elements such as a microwave transmission lines TRL1, TRL2 and TRL3, capacitors C1, C2 and C3, and inductors L1, L2 and L3 formed in the multilayer wiring substrate of the RF module. The main line and the sub line of the directional coupler (CPL) 13 are constituted of multilayer wirings formed in the multilayer wiring substrate of the RF module.

The RF signal from the other end of the main line of the directional coupler (CPL) 13 is supplied to the RF signal input terminal of the harmonic elimination filter (LPF) 14. The harmonic elimination filter (LPF) 14 transmits a basic frequency component of the RF signal supplied to the RF signal input terminal to the RF signal output terminal at an extremely small attenuation ratio. However, harmonic components such as double harmonic, triple harmonic and quadruple harmonic are attenuated at a large attenuation rate. Therefore, the harmonic elimination filter 14 functions as a low-pass filter (LPF). A parallel resonant frequency f5 of the parallel connection between the inductor L5 and the capacitor C5 in the harmonic elimination filter 14 is set to be approximately equal to the double harmonic. Due to the high impedance of the parallel connection between the inductor L5 and the capacitor C5 with the parallel resonant frequency f5, the double harmonic is attenuated at a large attenuation rate. A serial resonant frequency f4 of the serial connection between the inductor L4 and the capacitor C4 in the harmonic elimination filter 14 is set to be approximately equal to the triple harmonic. Due to the low impedance of the serial connection between the inductor L4 and the capacitor C5 with the serial resonant frequency f4, the triple harmonic is attenuated at a large attenuation rate. A serial resonant frequency f6 of the serial connection between the inductor L6 and the capacitor C6 in the harmonic elimination filter 14 is set to be approximately equal to the quadruple harmonic. Due to the low impedance of the serial connection between the inductor L6 and the capacitor C6 with the serial resonant frequency f6, the quadruple harmonic is attenuated at a large attenuation rate.

The RF signal from the RF signal output terminal of the harmonic elimination filter 14 is supplied to one end of the antenna switch 15, and the other end of the antenna switch 15 is connected to one end of the antenna 16. The RF signal from the output terminal of the harmonic elimination filter 14 is supplied to one terminal of the antenna switch 15 via the DC cut capacitor Cdc. The final-stage RF amplification output signal Pout from the final-stage amplifier 12a of the RF power amplifier HPA includes DC voltage component together with the RF signal component. The DC cut capacitor Cdc of the harmonic elimination filter 14 prevents the DC voltage component of the final-stage RF amplification output signal Pout from being transmitted to the antenna switch 15 and the antenna 16. The examination by the inventors of the present invention has revealed that the DC cut capacitor Cdc disposed between the output terminal of the harmonic elimination filter 14 and the antenna switch 15 facilitates the adjustment of phase rotation in the signal path constituted of the output matching circuit 12c, the directional coupler 13 and the harmonic elimination filter 14, and the distortion at the antenna switch 15 is reduced.

Further, the one end and the other end of the sub line of the directional coupler 13 are connected to a terminating resistor Rt and a detection voltage input terminal of the gain control unit 17 of the RF power amplifier HPA, respectively. A gain control signal Vramp from the base band signal processing unit and a detection voltage Vcpl from the directional coupler 13 are supplied to the gain control unit 17 via an RF analog signal processing semiconductor integrated circuit. The level of the gain control signal Vramp is in proportion to the distance between the base station and the mobile phone, and the level of the RF transmission signal RFout supplied from the RF power amplifier HPA to the antenna 16 can be controlled based on the level of the gain control signal Vramp. The gain control unit 17 performs APC operation by controlling the gain of the RF power amplifier HPA so that the level of the detection voltage Vcpl from the directional coupler 13 follows the level of the gain control signal Vramp. The APC is carried out by the gain control of the initial-stage amplifier 10a, the second-stage amplifier 11a and the final-stage amplifier 12a by the initial-stage bias circuit 10b, the second-stage bias circuit 11b and the final-stage bias circuit 12b which are controlled by the gain control unit 17.

### (Sixth Embodiment)

### <RF module enabling multi-band transmission>

FIG. 20 is a diagram showing a circuit configuration of an RF module according to the sixth embodiment of the present invention. The RF module enables multi-band transmission of GSM850, GSM900, DCS1800 and PCS1900. Therefore, a first frequency band RF signal RFin_LB is amplified by a first RF power amplifier HPA1, and a second frequency band RF signal RFin_HB is amplified by a second RF power amplifier HPA2. The first frequency band RF signal RFin_LB is an RF transmission signal for GSM850 and GSM900, and the second frequency band RF signal RFin_HB is an RF transmission signal for DCS1800 and PCS1900.

The frequency of the RF transmission signal of GSM850 is 824 MHz to 849 MHz, and the frequency of the RF transmission signal of GSM900 is 880 MHz to 915 MHz. Also, the frequency of the RF transmission signal of DCS1800 is 1710 MHz to 1780 MHz, and the frequency of the RF transmission signal of PCS1900 is 1850 MHz to 1910 MHz.

In an RF module 100 shown in FIG. 20, the first RF power amplifier HPA1 and the second RF power amplifier HPA2 are formed on a semiconductor integrated circuit chip IC_Chip. On a wiring substrate of the RF module 100 around the chip IC_Chip, a first output matching circuit 22c, a first directional coupler 23, a first harmonic elimination filter 24, a second output matching circuit 12c, a second directional coupler 13, a second harmonic elimination filter 14 and an antenna switch 15 are formed.

The chip IC_Chip has a substantially quadrangular shape. The chip IC_Chip has a first side Sd1 and a second side Sd2 which are opposed and substantially parallel to each other. The chip IC_Chip further has a third side Sd3 which is connected to the first side Sd1 and the second side Sd2 and disposed substantially perpendicular to the first side Sd1 and the second side Sd2 and a fourth side Sd4 which is opposed and substantially parallel to the third side Sd3.

A first output amplification signal Pout_LB of the first RF power amplifier HPA1 is led out from the first side Sd1 of the chip IC_Chip, and a second output amplification signal Pout_HB of the second RF power amplifier HPA2 is led out from the second side Sd2 of the chip IC_Chip.

The first detection signal Vcpl_LB from a sub line of the first directional coupler 23 is led into a first signal input terminal of a first gain control unit 27 for a first RF power amplifier HPA1 from the third side Sd3 of the chip IC_Chip. The second detection signal Vcpl_HB from a sub line of the second directional coupler 13 is led into a second signal input terminal of a second gain control unit 17 for a second RF power amplifier from the third side Sd3 of the chip IC_Chip.

The distance between the lead-out point of the first output amplification signal Pout LB on the first side Sd1 of the chip IC_Chip and the lead-in point of the first detection signal Vcpl_LB on the third side Sd3 of the chip IC_Chip can be increased. The distance between lead-out point of the second output amplification signal Pout_HB on the second side Sd2 of the chip IC_Chip and the lead-in point of the second detection signal Vcpl_HB on the third side Sd3 of the chip IC_Chip can be increased. Therefore, it is possible to reduce the level of the harmonic component contained in the output amplification signals Pout_LB and Pout_HB transmitted to the signal input terminals Vcpl_LB and Vcpl_HB of the gain control units 27 and 17.

Further, as shown in FIG. 20, between the lead-out point of the first output amplification signal Pout LB on the first side Sd1 and the lead-in point of the first detection signal Vcpl_LB on the third side Sd3, the lead-in point of the second detection signal Vcpl_HB on the third side Sd3 is disposed. Similarly, between the lead-out point of the second output amplification signal Pout_HB on the second side Sd2 and the lead-in point of the second detection signal Vcpl_HB on the third side Sd3, the lead-in point of the first detection signal Vcpl_LB on the third side Sd3 is disposed. Therefore, the level of the harmonic component of the output amplification signals Pout_LB and Pout_HB transmitted to the signal input terminals Vcpl_LB and Vcpl_HB of the gain control units 27 and 17 can be further reduced.

### <Wiring on RF module around the chip>

FIG. 21A and FIG. 21B show the wirings around the chip IC_Chip of the RF module 100 in FIG. 20. FIG. 21A is a plan view showing the wirings, and FIG. 21B is a perspective view of the same.

As shown in FIG. 21A, between the lead-out point of the first output amplification signal Pout_LB on the first side Sd1 and the lead-in point of the first detection signal Vcpl_LB on the third side Sd3, a first ground bonding wire 402 connected to a ground voltage GND is connected to the third side Sd3. From the lead-out point of the first output amplification signal Pout_LB on the first side Sd1 to a bonding wire 401 connected to the lead-in point of the first detection signal Vcpl_LB of the first gain control unit 27, a harmonic coupling signal path HD_LB_SP of the first output amplification signal Pout_LB indicated by a broken line exists. The first ground bonding wire 402 can effectively reduce the signal cross talk from the lead-out point of the first output amplification signal Pout LB to the lead-in point of the first detection signal Vcpl_LB via the coupling signal path HD_LB_SP. Also, between the lead-out point of the second output amplification signal Pout_HB on the second side Sd2 and the lead-in point of the second detection signal Vcpl_HB on the third side Sd3, a second ground bonding wire 404 connected to the ground voltage GND is connected to the third side Sd3. From the lead-out point of the second output amplification signal Pout_HB on the second side Sd2 to a bonding wire 405 connected to the lead-in point of the second detection signal Vcpl_HB of the second gain control unit 17, a harmonic coupling signal path HD_HB_SP of the second output amplification signal Pout_HB indicated by a broken line exists. The second ground bonding wire 404 can effectively reduce the signal cross talk from the lead-out point of the second output amplification signal Pout_HB to the lead-in point of the second detection signal Vcpl_HB via the coupling signal path HD_HB_SP.

Further, in FIG. 21A, six squares located on the left side of the third side Sd3 of the chip IC_Chip represent bonding pads on the chip IC_Chip to be connected to the bonding wires 400 to 406. Also, six rectangles located on the right side of third side Sd3 of the chip IC_Chip represent wiring areas on the wiring substrate surface of the RF module 100 to be connected to the bonding wires 400 to 406.

The perspective view in FIG. 21B stereoscopically illustrates that the second ground bonding wire 404 effectively reduces the signal cross talk from the lead-out point of the second output amplification signal Pout_HB on the second side Sd2 to the lead-in point of the second detection signal Vcpl_HB on the third side Sd3 via the coupling signal path HD_HB_SP. Each of the bonding wires 400 to 406 has a wiring distance which is relatively high and long around the four sides of the chip IC_Chip. The ground bonding wires 400 and 402 disposed on the right and left sides of the bonding wire 401 connected to the lead-in point of the first detection signal Vcpl_LB of the first gain control unit 27 effectively reduce the harmful cross talk. Similarly, the ground bonding wires 404 and 406 disposed on the right and left sides of the bonding wire 405 connected to the lead-in point of the second detection signal Vcpl_HB of the second gain control unit 17 effectively reduce the harmful cross talk.

### (Seventh Embodiment)

### <Specific RF module enabling multi-band transmission>

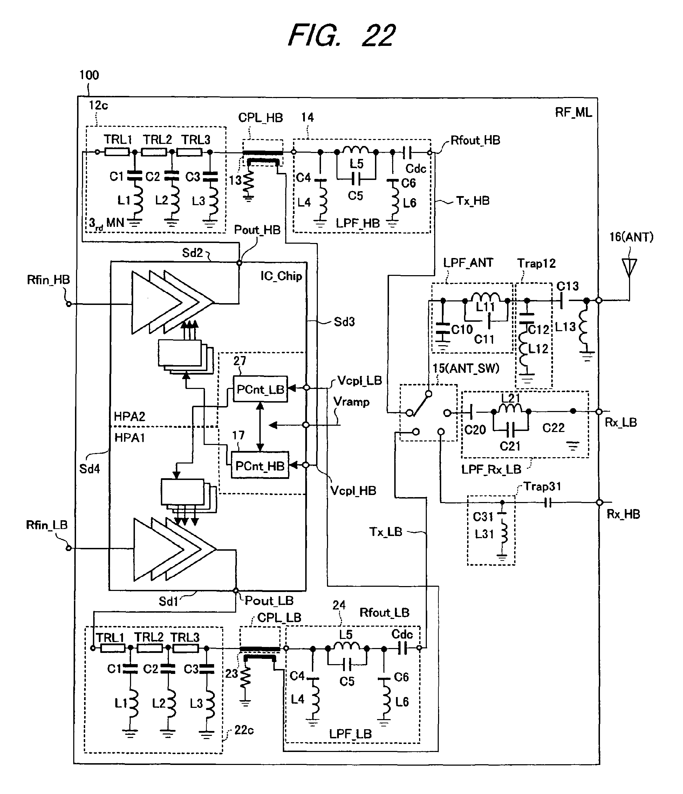

FIG. 22 is a diagram showing a circuit configuration of a specific RF module according to the seventh embodiment of the present invention. The basic difference of the specific RF module shown in FIG. 22 from the RF module shown in FIG. 20 is an antenna switch 15.

In the specific RF module shown in FIG. 22, the antenna switch 15 functions to switch over between a transmission slot and a reception slot of a TDMA (time division multiple access) system supporting multiple bands of GSM850, GSM900, DCS1800 and PCS1900. More specifically, for the transmission slot, the antenna switch 15 selects either a first RF transmission signal Tx_LB or a second RF transmission signal Tx_LH and supplies the signal to an antenna 16. The first RF transmission signal Tx_LB is an RF transmission signal for GSM850 and GSM900 based on the first output amplification signal Pout_LB of the first RF power amplifier HPA1, and the second RF transmission signal Tx_LH is an RF transmission signal for DCS1800 and PCS1900 based on the second output amplification signal Pout_HB of the second RF power amplifier HPA2.

Also, for the reception slot, the antenna switch 15 transmits an RF reception signal received by the antenna 16 to a selected signal terminal of the first RF reception signal terminal Rx_LB and the second RF reception signal terminal Rx_LH. The RF reception signal of the first RF reception signal terminal Rx_LB is an RF reception signal for GSM850 or GSM900, and the RF reception signal of the second RF reception signal terminal Rx_LH is an RF reception signal for DCS1800 or PCS1900.

In the specific RF module shown in FIG. 22, a low-pass filter LPF_ANT, a trap filter Trap12, a capacitor C13 and an inductor L13 are connected to a common input/output terminal of the antenna switch 15. The low-pass filter LPF_ANT is constituted of capacitors C10 and C11 and an inductor L11 so as to attenuate triple harmonic contained in the high band for DCS1800 and PCS1900. The trap filter Trap 12 is constituted of a capacitor C12 and an inductor L12 so as to absorb external surge voltage from a relatively low frequency to nearly direct current in the RF signal.

A low-pass filter LPF_Rx_LB is connected between the antenna switch 15 and the first RF reception signal terminal Rx_LB. The low-pass filter LPF_Rx_LB is constituted of capacitors C20, C21 and C22 and an inductor L21 so as to attenuate triple harmonic contained in the low band for GSM850 and GSM900.

A trap filter Trap31 is connected between the antenna switch 15 and the second RF reception signal terminal Rx_HB. The trap filter Trap31 is constituted of a capacitor C31 and an inductor L31 so as to absorb external surge voltage from a relatively low frequency to nearly direct current contained in the RF signal.

### <Cellular phone>

FIG. 23 is a block diagram showing a configuration of a mobile phone in which the RF module (100) shown in FIG. 22, a radio frequency analog signal processing semiconductor integrated circuit (RF_IC) and a base band signal processing LSI (BB_LSI) are mounted.

The RF module (RF_ML) 100 shown in FIG. 23 includes an antenna switch 15, a semiconductor chip IC_Chip, a first output matching circuit 22c, a first directional coupler 23, a first harmonic elimination filter 24, a second output matching circuit 12c, a second directional coupler 13 and a second harmonic elimination filter 14. The antenna switch 15 is constituted of an antenna switch microwave monolithic semiconductor integrated circuit (ANT_SW) 15, and the semiconductor chip IC_Chip includes RF power amplifiers HPA1 and HPA2.

A common input/output terminal I/O of an antenna switch MMIC (ANT_SN) 15 of the RF module (RF_ML) 100 is connected to a transmitting/receiving antenna ANT16 of the mobile phone. The control signal B.B_Cnt from the base band signal processing LSI (BB_LSI) is supplied to the RF module (RF_ML) 100 via a radio frequency analog signal processing semiconductor integrated circuit (RF_IC) (hereinafter, referred to as RFIC). The flow of the radio frequency signal from the transmitting/receiving antenna 16 to the common input/output terminal I/O corresponds to a reception operation RX in the mobile phone, and the flow of the radio frequency signal from the common input/output terminal I/O to transmitting/receiving antenna 16 corresponds to a transmission operation TX in the mobile phone.

RFIC (RF_IC) performs frequency-up conversion of a transmission base band signal Tx_BBS from the base band signal processing LSI (BB_LSI) to a radio frequency transmission signal. Further, RFIC (RF_IC) also performs frequency-down conversion of a radio frequency reception signal received by the transmitting/receiving antenna ANT to a reception base band signal Rx_BBS. The reception base band signal Rx_BBS is supplied to the base band signal processing LSI (BB_LSI).

The antenna switch MMIC (ANT_SW) 15 of the RF module (RF_ML) 100 establishes a signal path between the common input/output terminal I/O and any one of transmission terminals Tx1 and Tx2 and reception terminals Rx1 and Rx2, and performs either the reception operation RX or the transmission operation TX. The antenna switch MMIC (ANT_SW) 15 sets the impedance of signal paths other than the signal path established for either the reception operation RX or the transmission operation TX to an extremely high value, thereby obtaining a necessary isolation.

The base band signal processing LSI (BB_LSI) is connected to an external nonvolatile memory (not shown) and an application processor (not shown). The application processor is connected to a liquid crystal display device (not shown) and a key entry device (not shown), thereby executing various application programs such as a general-purpose program and a game. A boot program (start-up initialize program) of a mobile device such as a mobile phone, an operation system program (OS), a program for phase-demodulation of a reception base band signal and phase-modulation of a transmission base band signal for the GSM system by a digital signal processor (DSP) in the base band signal processing LSI, various kinds of application programs and the like can be stored in an external nonvolatile memory.

The case where the transmission base band signal Tx_BBS from the base band signal processing LSI (BB_LSI) is to be subjected to the frequency-up conversion to a transmission frequency band for GSM850 or GSM900 is assumed. Note that the frequency of the RF transmission signal for GSM850 is 824 MHz to 849 MHz, and the frequency of the RF transmission signal for GSM900 is 880 MHz to 915 MHZ. In this case, the transmission signal processing unit Tx_SPU of RFIC performs a frequency-up conversion of the transmission base band signal Tx_BBS to the transmission frequency band, thereby generating a radio frequency transmission signal RF_Tx1. The radio frequency transmission signal RF_Tx1 of the transmission frequency band is subjected to power amplification at the RF high output power amplifier HPA1 of the RF module RF_ML and is supplied to the transmission terminal Tx1 of the antenna switch MMIC (ANT_SW) 15 via the low-pass filter 12c. The radio frequency transmission signal RF_Tx1 for GSM850 or GSM900 supplied to the transmission terminal Tx1 can be transmitted from the transmitting/receiving antenna (ANT) 16 via the common input/output terminal I/O.

The radio frequency reception signal RF_Rx1 for GSM850 or GSM900 received by the transmitting/receiving antenna (ANT) 16 is supplied to the common input/output terminal I/O of the antenna switch MMIC (ANT_SW) 15. Note that the frequency of the RF reception signal for GSM850 is 869 MHz to 894 MHz, and the frequency of the RF reception signal for GSM 900 is 925 MHz to 960 MHz. The radio frequency reception signal RF_Rx1 of the reception frequency band obtained from the reception terminal Rx1 of the antenna switch 15 is amplified by a low-noise amplifier LNA1 of RFIC via a surface acoustic wave filter SAW1, and then supplied to a reception signal processing unit Rx_SPU. The reception signal processing unit Rx_SPU performs the frequency-down conversion of the radio frequency reception signal GSM_Rx for GSM to a reception base band signal Rx_BBS.

In a transmission/reception mode for GSM850 or GSM900, in response to the control signal B.B_Cnt, the antenna switch 15 performs the transmission of the radio frequency transmission signal RF_Tx1 by connecting the common input/output terminal I/O and the transmission terminal Tx1 and performs the reception of the radio frequency reception signal RF_Rx1 by connecting the common input/output terminal I/O and the reception terminal Rx1 in a time division manner.

The case where the transmission base band signal Tx_BBS from the base band signal processing LSI (BB_LSI) is to be subjected to the frequency-up conversion to the transmission frequency band for DCS1800 or PCS1900 is assumed. Note that the frequency of the RF transmission signal for DCS1800 is 1710 MHz to 1780 MHz, and the frequency of the RF transmission signal for PCS1900 is 1850 MHz to 1910 MHz. In this case, the transmission signal processing unit Tx_SPU of RFIC performs a frequency-up conversion of the transmission base band signal Tx_BBS to the transmission frequency band, thereby generating a radio frequency transmission signal RF_Tx2 of the transmission frequency band. The radio frequency transmission signal RF_Tx2 of the transmission frequency band is subjected to power amplification at the RF high output power amplifier HPA2 of the RF module 100 and is supplied to the transmission terminal Tx2 of the antenna 15 via the low-pass filter 22c. The radio frequency transmission signal RF_Tx2 for DCS1800 or PCS1900 supplied to the transmission terminal Tx2 can be transmitted from the transmitting/receiving antenna (ANT) 16 via the common input/output terminal I/O.

The radio frequency reception signal RF_Rx2 for DCS1800 or PCS1900 received by the transmitting/receiving antenna (ANT) 16 is supplied to the common input/output terminal I/O of the antenna switch 15. Note that the frequency of the RF reception signal for DCS1800 is 1805 MHz to 1880 MHz, and the frequency of the RF reception signal for PCS1900 is 1930 MHz to 1990 MHz. The radio frequency reception signal RF_Rx2 for DCS1800 or PCS1900 obtained from the reception terminal Rx2 of the antenna switch 15 is amplified by a low-noise amplifier LNA2 of RFIC via a surface acoustic wave filter SAW2, and then supplied to the reception signal processing unit Rx_SPU. The reception signal processing unit Rx_SPU performs the frequency-down conversion of the radio frequency reception signal RF_Rx2 for DCS1800 or PCS1900 to the reception base band signal Rx_BBS.

In a transmission/reception mode for DCS1800 or PCS1900, in response to the control signal B.B_Cnt, the antenna switch 15 performs the transmission of the radio frequency transmission signal RF_Tx2 by connecting the common input/output terminal I/O and the transmission terminal Tx2 and performs the reception of the radio frequency reception signal RF_Rx2 by connecting the common input/output terminal I/O and the reception terminal Rx2 in a time division manner.

### <Antenna switch MMIC>

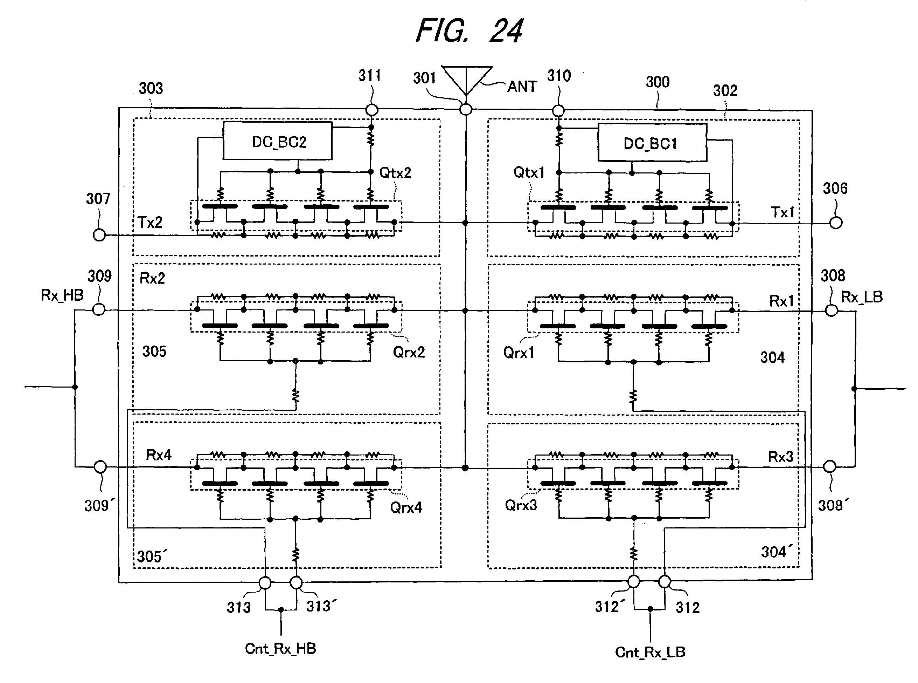

FIG. 24 is a circuit diagram showing an antenna switch microwave monolithic semiconductor integrated circuit (MMIC) 300 constituting the antenna switch 15 of the RF module shown in FIG. 22.

The antenna switch MMIC (300) shown in FIG. 24 establishes a signal path between a common input/output terminal I/O (301) and any one of the terminals of transmission terminals Tx1 (306) and Tx2 (307) and reception terminals Rx1 (308), Rx2 (309), Rx3 (308') and Rx4 (309') to perform either the reception operation RX or the transmission operation TX. The antenna switch MMIC (300) sets the impedance of signal paths other than the signal path established for either the reception operation RX or the transmission operation TX to an extremely high value, thereby obtaining a necessary isolation. In the field of an antenna switch, the common input/output terminal I/O (301) is called as single pole. Also, the total of six terminals of transmission terminals Tx1 (306) and Tx2 (307) and reception terminals Rx1 (308), Rx2 (309), Rx3 (308') and Rx4 (309') are called as 6 throws. Therefore, the antenna switch MMIC (300) in FIG. 23 is a single-pole 6-throw switch (SP6T).

The antenna switch MMIC (300) includes six radio frequency switches 302, 303, 304, 305, 304' and 305'.

The first transmission switch 302 connects between the common input/output terminal I/O (301) and the first transmission terminal Tx1 (306), thereby establishing a path for a first transmission signal from the first transmission terminal Tx1 (306) to the common input/output terminal I/O (301). The second transmission switch 303 connects between the common input/output terminal I/O (301) and the second transmission terminal Tx2 (307), thereby establishing a path for a second transmission signal from the second transmission terminal Tx2 (307) to the common input/output terminal I/O (301).

The first reception switch 304 connects between the common input/output terminal I/O (301) and the first reception terminal Rx1 (308), thereby establishing a path for a first reception signal from the common input/output terminal I/O (301) to the first reception terminal Rx1 (308). The second reception switch 305 connects between the common input/output terminal I/O (301) and the second reception terminal Rx2 (309), thereby establishing a path for a second reception signal from the common input/output terminal I/O (301) to the second reception terminal Rx2 (309). The third reception switch 304' connects between the common input/output terminal I/O (301) and the third reception terminal Rx1 (308'), thereby establishing a path for a third reception signal from the common input/output terminal I/O (301) to the third reception terminal Rx1 (308'). The fourth reception switch 305' connects between the common input/output terminal I/O (301) and the fourth reception terminal Rx2 (309'), thereby establishing a path for a fourth reception signal from the common input/output terminal I/O (301) to the fourth reception terminal Rx2 (309').

In the antenna switch which is an SP6T switch in FIG. 24, the first reception switch 304 and the third reception switch 304' are connected in parallel, and the second reception switch 305 and the fourth reception switch 305' are connected in parallel. Therefore, the SP6T-switch substantially functions as an SP4T switch. By connecting the switches in parallel, signal loss in a reception mode can be reduced.

Note that, for radio frequency switches Qtx1, Qtx2, Qrx1, Qrx2, Qrx3 and Qrx4 constituting the six radio frequency switches 302, 303, 304, 305, 304' and 305', heterojunction HEMTs (High Electron Mobility Transistor) having a low ON-resistance are used.

Further, the first transmission switch 302 includes a first DC boost circuit DC_BC1, and the second transmission switch 303 includes a second DC boost circuit DC_BC2.

In response to a high level first RF transmission signal supplied from the first RF power amplifier HPA1 to the transmission terminal Tx1 (306), the first DC boost circuit DC_BC1 of the first transmission switch 302 boosts an approximately 3V DC control voltage supplied to a first transmission control terminal 310. A high level boosted output voltage of approximately 5 V generated by the first DC boost circuit DC_BC1 is supplied to a gate of a FET Qtx1 of the first transmission switch 302.

As a result, an ON-resistance Ron of the FET Qtx1 of the first transmission switch 302 can be largely reduced, and the signal loss of the RF transmission signal at the transmission operation can be reduced. Also, due to the high level boosted output voltage of approximately 5 V, the voltage of the common input/output terminal I/O (301) is also boosted to a high level of approximately 4 V. The gates of the FETs Qtx2, Qrx1, Qrx2, Qrx3 and Qrx4 of the other switches 303, 304, 305, 304' and 305' are set to a low voltage of approximately 0 V. The gate-source capacitance of the FETs Qtx2, Qrx1, Qrx2, Qrx3 and Qrx4 is reduced to an extremely small value, and thus the harmonic distortion of the antenna switch MMIC (300) can be largely reduced.

In response to a high level second RF transmission signal supplied from the second RF power amplifier HPA2 to the transmission terminal Tx2 (307), the second DC boost circuit DC_BC2 of the second transmission switch 303 boosts an approximately 3V DC control voltage supplied to a second transmission control terminal 311. A high level boosted output voltage of approximately 5 V generated by the second DC boost circuit DC_BC2 is supplied to a gate of a FET Qtx2 of the second transmission switch 303.

As a result, an ON-resistance Ron of the FET Qtx2 of the second transmission switch 303 can be largely reduced, and the signal loss of the RF transmission signal at the transmission operation can be reduced. Also, due to the high level boosted output voltage of approximately 5 V, the voltage of the common input/output terminal I/O (301) is also boosted to a high level of approximately 4 V. The gates of the FETs Qtx1, Qrx1, Qrx2, Qrx3 and Qrx4 of the other switches 302, 304, 305, 304' and 305' are set to a low voltage of approximately 0 V. The gate-source capacitance of the FETs Qtx1, Qrx1, Qrx2, Qrx3 and Qrx4 is reduced to an extremely small value, and thus the harmonic distortion of the antenna switch MMIC (300) can be largely reduced.

In the foregoing, the invention made by the inventors of the present invention has been concretely described based on the embodiments. However, it is needless to say that the present invention is not limited to the foregoing embodiments and various modifications and alterations can be made within the scope of the present invention.

For example, the power transistors constituting the initial-stage amplifiers 10a and 20a, the second-stage amplifiers 11a and 21a and the final-stage amplifiers 12a and 22a of the first and second RF power amplifiers HPA1 and HPA2 are not limited to silicon power MOSFETs with LD structure. The power transistors can be replaced with MESFETs using chemical compound semiconductors such as GaAs and InP or N-channel field effect transistors of HEMT. Further, the power transistors can be replaced with NPN HBTs (heterojunction bipolar transistor) using GaAs, InGaAs or silicon germanium.

Also, the microwave transmission lines TRL1, TRL2 and TRL3, the capacitors C1, C2 and C3 and inductors L1, L2 and L3 of the output matching circuits 12c and 22c are not limited to discreet elements in the RF module. These components can be integrated on a GaAs semiconductor substrate, a glass insulating substrate, a low temperature sintered ceramic substrate, an epoxy insulating substrate or the like. More specifically, an integrated passive device obtained by integrating capacitors, inductors and the like on an insulating substrate can be employed.

Further, in the radio frequency switches of the antenna switch MMIC (300) in FIG. 24, the FETs Qtx1, Qtx2, Qrx1, Qrx2, Qrx3 and Qrx4 can be replaced with N-channel depletion insulated gate MOS transistors instead of the HEMT transistors. In this case, a bias voltage of approximately 4 V is supplied to the common input/output terminal I/O. In the case where the mobile phone system uses a single power source voltage of approximately 3 V, a booster circuit such as a charge pump circuit for boosting the single power source voltage of approximately 3 V to a bias voltage of approximately 4 V is included in the antenna switch MMIC (300) in FIG. 24.

Furthermore, in the RF module 100 in FIG. 20 and FIG. 22, the first directional coupler 23 and the second directional coupler 13 can be replaced with a microcoupler. The microcoupler has a capacitive element connected between the main line and the sub line thereof. In the microcoupler, the capacitive coupling between the main line and the sub line via a capacitive element is added to an ordinary electromagnetic coupling. Therefore, the wiring distance between the main line and the sub line can be reduced shorter than an ordinary 1/4 wavelength (λ/4). As a result, by using the microcoupler for the first directional coupler 23 and the second directional coupler 13, the RF module 100 shown in FIG. 20 and FIG. 22 can be miniaturized.

The electronic device and the RF module according to an embodiment of the present invention are particularly useful when applied to radio frequency power amplifying modules supporting multiple bands used for a portable telephone and the like. In addition, the electronic device and the RF module can be widely applied to various types of devices such as oscillators and radio communication devices including the same.

## Claims

1. An electronic device formed in a multilayer wiring substrate including a first wiring layer, a second wiring layer disposed below the first wiring layer and a third wiring layer disposed below the second wiring layer, the electronic device comprising:
a first wiring pattern formed in the first wiring layer so as to include an approximately loop-shaped line with a predetermined line width or more, and having a first node for inputting/outputting a signal at one end thereof;
a second wiring pattern formed in the second wiring layer so as to include an approximately loop-shaped line with a predetermined line width or more, and having a second node for inputting/outputting a signal at one end thereof;
a third wiring pattern formed in the third wiring layer so as to include an approximately loop-shaped line with a line width narrower than the predetermined width or formed so as to include a plurality of approximately loop-shaped lines with a line width narrower than the predetermined width over the third wiring layer and its underlying wiring layer;
a first via hole conductor electrically connecting other end of the first wiring pattern and one end of the third wiring pattern; and
a second via hole conductor electrically connecting other end of the second wiring pattern and other end of the third wiring pattern,
wherein the first wiring pattern, the second wiring pattern and the third wiring pattern are formed so as to overlap each other, and an overlapping area of the first wiring pattern and the second wiring pattern is larger than an overlapping area of the second wiring pattern and the third wiring pattern.

2. The electronic device according to claim 1,
wherein the one end of the first wiring pattern, the one end of the second wiring pattern and the other end of the third wiring pattern are disposed in an outer peripheral portion of the respective wiring patterns, and
the other end of the first wiring pattern and the one end of the third wiring pattern are disposed inside a loop of the respective wiring patterns.

3. The electronic device according to claim 1,
wherein the multilayer wiring substrate includes a lower wiring layer below the third wiring pattern or an upper wiring layer above the first wiring layer, and
the lower wiring layer or the upper wiring layer serves as a ground electrode connected to a ground potential.

4. The electronic device according to claim 1,
wherein the multilayer wiring substrate further includes a fourth wiring layer disposed below the third wiring layer,
the third wiring pattern includes a first approximately loop-shaped line formed of the third wiring layer and a second approximately loop-shaped line formed of the fourth wiring layer,
one end of the first line is the one end of the third wiring pattern,
other end of the second line is the other end of the third wiring pattern, and
other end of the first line is electrically connected to one end of the second line via a third via hole conductor.

5. The electronic device according to claim 1,
wherein the electronic device constitutes a resonant circuit, includes a capacitive element constituted of the first wiring pattern and the second wiring pattern, and includes an inductor constituted of the third wiring pattern.

6. An RF module, comprising:
an electronic device formed in a multilayer wiring substrate including a first wiring layer, a second wiring layer disposed below the first wiring layer and a third wiring layer disposed below the second wiring layer, the electronic device comprising
a first wiring pattern formed in the first wiring layer so as to include an approximately loop-shaped line with a predetermined line width or more, and having a first node for inputting/outputting a signal at one end thereof,
a second wiring pattern formed in the second wiring layer so as to include an approximately loop-shaped line with a predetermined line width or more, and having a second node for inputting/outputting a signal at one end thereof,
a third wiring pattern formed in the third wiring layer so as to include an approximately loop-shaped line with a line width narrower than the predetermined width or formed so as to include a plurality of approximately loop-shaped lines with a line width narrower than the predetermined width over the third wiring layer and its underlying wiring layer,
a first via hole conductor electrically connecting other end of the first wiring pattern and one end of the third wiring pattern, and
a second via hole conductor electrically connecting other end of the second wiring pattern and other end of the third wiring pattern,
in which the first wiring pattern, the second wiring pattern and the third wiring pattern are formed so as to overlap each other, and an overlapping area of the first wiring pattern and the second wiring pattern is larger than an overlapping area of the second wiring pattern and the third wiring pattern;
a first semiconductor chip including a power amplifier circuit for amplifying an inputted signal to output the amplified signal, and mounted on the multilayer wiring substrate; and
a second semiconductor chip including an antenna switch circuit for receiving an output from the power amplifier circuit, mounted on the multilayer wiring substrate, and connected to any one of the first node and the second node of the electronic device.

7. An electronic device formed in a multilayer wiring substrate including a first wiring layer, a second wiring layer disposed below the first wiring layer, a third wiring layer disposed below the second wiring layer and a fourth wiring layer disposed below the third wiring layer, the electronic device comprising:
a first wiring pattern formed in the first wiring layer so as to include an approximately loop-shaped line, and having a first node for inputting/outputting a signal at one end thereof;
a second wiring pattern formed in the second wiring layer so as to include an approximately loop-shaped line, and having a second node for inputting/outputting a signal at one end thereof;
a third wiring pattern formed into a plane shape in the third wiring layer; and
a fourth wiring pattern formed into a plane shape in the fourth wiring layer,
wherein other end of the first wiring pattern and other end of the second wiring pattern are electrically connected to each other via a first via hole conductor,
the third wiring pattern and the fourth wiring pattern are disposed opposing to each other,
one pattern of the third wiring pattern and the fourth wiring pattern is electrically connected to the first node via a second via hole conductor,
other pattern of the third wiring pattern and the fourth wiring pattern is electrically connected to the second node via a third via hole conductor, and
the first wiring pattern, the second wiring pattern, the third wiring pattern and the fourth wiring pattern are formed overlapping each other, and an overlapping area of the third wiring pattern and the fourth wiring pattern is larger than an overlapping area of the second wiring pattern and the third wiring pattern.

8. The electronic device according to claim 7,
wherein the third wiring pattern and the fourth wiring pattern are disposed inside an outer periphery of the first wiring pattern or the second wiring pattern.

9. The electronic device according to claim 7,
wherein the multilayer wiring substrate has a fifth wiring layer below the fourth wiring layer or a sixth wiring layer above the first wiring layer, and
the fifth wiring layer or the sixth wiring layer serves as a ground electrode connected to a ground potential.

10. The electronic device according to claim 7,
wherein the third wiring pattern is electrically connected to the first node via the second via hole conductor, and
the fourth wiring pattern is electrically connected to the second node via the third via hole conductor.

11. The electronic device according to claim 10,
wherein the one end and the other end of the first wiring pattern, the one end and the other end of the second wiring pattern, the first via hole conductor and the third via hole conductor are disposed outside an outer periphery of the third wiring pattern.

12. The electronic device according to claim 7,
wherein the electronic device constitutes a resonant circuit, includes an inductor constituted of the first wiring pattern and the second wiring pattern, and includes a capacitive element constituted of the third wiring pattern and the fourth wiring pattern.

13. An RF module, comprising:
an electronic device formed in a multilayer wiring substrate including a first wiring layer, a second wiring layer disposed below the first wiring layer, a third wiring layer disposed below the second wiring layer and a fourth wiring layer disposed below the third wiring layer, the electronic device comprising
a first wiring pattern formed in the first wiring layer so as to include an approximately loop-shaped line, and having a first node for inputting/outputting a signal at one end thereof,
a second wiring pattern formed in the second wiring layer so as to include an approximately loop-shaped line, and having a second node for inputting/outputting a signal at one end thereof,
a third wiring pattern formed into a plane shape in the third wiring layer, and
a fourth wiring pattern formed into a plane shape in the fourth wiring layer,
in which other end of the first wiring pattern and other end of the second wiring pattern are electrically connected to each other via a first via hole conductor,
the third wiring pattern and the fourth wiring pattern are disposed opposing to each other,
one pattern of the third wiring pattern and the fourth wiring pattern is electrically connected to the first node via a second via hole conductor,
other pattern of the third wiring pattern and the fourth wiring pattern is electrically connected to the second node via a third via hole conductor, and
the first wiring pattern, the second wiring pattern, the third wiring pattern and the fourth wiring pattern are formed overlapping each other, and an overlapping area of the third wiring pattern and the fourth wiring pattern is larger than an overlapping area of the second wiring pattern and the third wiring pattern;
a first semiconductor chip including a power amplifier circuit for amplifying an inputted signal to output the amplified signal, and mounted on the multilayer wiring substrate; and
a second semiconductor chip including an antenna switch circuit for receiving an output from the power amplifier circuit, mounted on the multilayer wiring substrate, and connected to any one of the first node and the second node of the electronic device.

14. An RF module formed in a multilayer wiring substrate including a first wiring layer, a second wiring layer disposed below the first wiring layer, a third wiring layer disposed below the second wiring layer and a fourth wiring layer disposed below the third wiring layer, the RF module comprising:
a first resonant circuit including a first wiring pattern formed in the first wiring layer and having a first node for inputting or outputting a signal at one end thereof, a second wiring pattern formed in the second wiring layer and having a second node for outputting or inputting a signal at one end thereof, and a third wiring pattern formed in the third wiring layer or over the third wiring layer and its underlying wiring layer;
a second resonant circuit including a fourth wiring pattern formed in the first wiring layer and having a third node for inputting or outputting a signal at one end thereof, a fifth wiring pattern formed in the second wiring layer and having a fourth node for outputting or inputting a signal at one end thereof, a sixth wiring pattern formed in the third wiring layer and a seventh wiring pattern formed in the fourth wiring layer;
a first semiconductor chip including a power amplifier circuit for amplifying an inputted signal to output the amplified signal, and mounted on the multilayer wiring substrate; and
a second semiconductor chip including an antenna switch circuit for receiving an output from the power amplifier circuit, mounted on the multilayer wiring substrate, and connected to either of the first node or the second node of the first resonant circuit and to either of the third node or the fourth node of the second resonant circuit,
wherein a capacitance value of a capacitor formed from the first wiring pattern and the second wiring pattern of the first resonant circuit is larger than a capacitance value of a capacitor formed from the sixth wiring pattern and the seventh wiring pattern of the second resonant circuit, and
a signal of a first frequency is inputted to the first resonant circuit, and a signal of a second frequency higher than the first frequency is inputted to the second resonant circuit.

15. The RF module according to claim 14,
wherein the first and second wiring patterns and the sixth and seventh wiring patterns are formed so as to overlap each other, and
an overlapping area of the first wiring pattern and the second wiring pattern of the first resonant circuit is larger than an overlapping area of the sixth wiring pattern and the seventh wiring pattern of the second resonant circuit.

16. An RF module formed in a multilayer wiring substrate including a first wiring layer, a second wiring layer disposed below the first wiring layer, a third wiring layer disposed below the second wiring layer and a fourth wiring layer disposed below the third wiring layer, the RF module comprising:
a first resonant circuit comprising a first wiring pattern formed in the first wiring layer and having a first node for inputting or outputting a signal at one end thereof, a second wiring pattern formed in the second wiring layer and having a second node for outputting or inputting a signal at one end thereof, and a third wiring pattern formed in the third wiring layer or over the third wiring layer and its underlying wiring layer,
in which other end of the first wiring pattern is electrically connected to one end of the third wiring pattern, and
other end of the third wiring pattern is electrically connected to other end of the second wiring pattern;
a second resonant circuit comprising a fourth wiring pattern formed in the first wiring layer and having a third node for inputting or outputting a signal at one end thereof, a fifth wiring pattern formed in the second wiring layer and having a fourth node for outputting or inputting a signal at one end thereof, a sixth wiring pattern formed to have a plane shape in the third wiring layer and a seventh wiring pattern formed to have a plane shape in the fourth wiring layer,
in which other end of the fourth wiring pattern is electrically connected to other end of the fifth wiring pattern,
the sixth wiring pattern is electrically connected to the third node at the one end of the fourth wiring pattern, and
the seventh wiring pattern is electrically connected to the fourth node at the one end of the fifth wiring pattern;
a first semiconductor chip including a power amplifier circuit for amplifying an inputted signal to output the amplified signal, and mounted on the multilayer wiring substrate; and
a second semiconductor chip including an antenna switch circuit for receiving an output from the power amplifier circuit, mounted on the multilayer wiring substrate, and connected to either of the first node or the second node of the first resonant circuit and connected to either of the third node or the fourth node of the second resonant circuit,
wherein a capacitance value of a capacitor formed from the first wiring pattern and the second wiring pattern of the first resonant circuit is larger than a capacitance value of a capacitor formed from the sixth wiring pattern and the seventh wiring pattern of the second resonant circuit, and
a signal of a first frequency is inputted to the first resonant circuit, and a signal of a second frequency higher than the first frequency is inputted to the second resonant circuit.

17. The RF module according to claim 16,
wherein the first and second wiring patterns and the sixth and seventh wiring patterns are formed so as to overlap each other, and
an overlapping area of the first wiring pattern and the second wiring pattern of the first resonant circuit is larger than an overlapping area of the sixth wiring pattern and the seventh wiring pattern of the second resonant circuit.

18. An electronic device, comprising:
a resonant circuit formed in a multilayer wiring substrate including a first wiring layer,
wherein a wiring layer includes a wiring pattern formed so as to include an approximately loop-shaped line, and
the wiring pattern is formed in a meandering shape.

19. An RF module, comprising:
an RF power amplifier; an output matching circuit; a directional coupler; and a harmonic elimination filter,
wherein an output amplification signal from the RF power amplifier is supplied to an input terminal of the output matching circuit,
an RF signal from an output terminal of the output matching circuit is supplied to an input terminal of the harmonic elimination filter via a main line of the directional coupler,
a detection signal from a sub line of the directional coupler is supplied to a signal input terminal of a gain control unit of the RF power amplifier, and
an RF signal from an output terminal of the harmonic elimination filter can be transmitted to an antenna.

20. The RF module according to claim 19, further comprising:
an antenna switch, to one terminal of which the RF signal from the output terminal of the harmonic elimination filter is supplied, and from other terminal of which an RF signal can be transmitted to the antenna.

21. The RF module according to claim 20,
wherein the RF signal from the output terminal of the harmonic elimination filter is supplied to the one terminal of the antenna switch via a DC cut capacitor.

22. The RF module according to claim 19,
wherein the RF power amplifier includes a multistage amplifier and a bias circuit controlled by the gain control unit to control a gain of the multistage amplifier.

23. The RF module according to claim 19,
wherein the output matching circuit reduces a signal reflection due to a difference between an output impedance for generating the output amplification signal of the RF power amplifier and an impedance of the antenna.

24. The RF module according to claim 22,
wherein the multistage amplifier, the bias circuit and the gain control unit are formed in a semiconductor integrated circuit chip.

25. The RF module according to claim 19,
wherein the directional coupler is a microcoupler having a capacitive element connected between a main line and a sub line thereof.

26. An RF module, comprising:
a first RF power amplifier; a first output matching circuit; a first directional coupler; a first harmonic elimination filter; a second RF power amplifier; a second output matching circuit; a second directional coupler; and a second harmonic elimination filter,
wherein the first RF power amplifier is configured to amplify a first frequency band RF signal, and the second RF power amplifier is configured to amplify a second frequency band RF signal with a frequency higher than that of the first frequency band RF signal,
a first output amplification signal from the first RF power amplifier is supplied to an input terminal of the first output matching circuit, a first RF signal from an output terminal of the first output matching circuit is supplied to an input terminal of the first harmonic elimination filter via a main line of the first directional coupler, a first detection signal from a sub line of the first directional coupler is supplied to a first signal input terminal of a first gain control unit for the first RF power amplifier, and a first RF signal from an output terminal of the first harmonic elimination filter can be transmitted to an antenna, and
a second output amplification signal of the second RF power amplifier is supplied to an input terminal of the second output matching circuit, a second RF signal from an output terminal of the second output matching circuit is supplied to an input terminal of the second harmonic elimination filter via a main line of the second directional coupler, a second detection signal from a sub line of the second directional coupler is supplied to a second signal input terminal of a second gain control unit for the second RF power amplifier, and a second RF signal from an output terminal of the second harmonic elimination filter can be transmitted to the antenna.

27. The RF module according to claim 26,
wherein the first RF signal from the output terminal of the first harmonic elimination filter is supplied to a first input terminal of an antenna switch, the second RF signal from the output terminal of the second harmonic elimination filter is supplied to a second input terminal of the antenna switch, and an RF signal from an output terminal of the antenna switch can be transmitted to the antenna.

28. The RF module according to claim 27,
wherein the first RF signal from the output terminal of the first harmonic elimination filter is supplied to the first input terminal of the antenna switch via a first DC cut capacitor, and the second RF signal from the output terminal of the second harmonic elimination filter is supplied to the second input terminal of the antenna switch via a second DC cut capacitor.

29. The RF module according to claim 26,
wherein the first RF power amplifier, the second RF power amplifier, the first gain control unit and the second gain control unit are formed in a semiconductor integrated circuit chip,
the semiconductor integrated circuit chip has a substantially quadrangular shape,
the chip has a first side and a second side which are opposed and substantially parallel to each other, a third side which is connected to the first side and the second side and disposed substantially perpendicular to the first side and the second side, and a fourth side which is opposed and substantially parallel to the third side,
the first output amplification signal from the first RF power amplifier is led out from the first side of the chip, and the second output amplification signal from the second RF power amplifier is led out from the second side of the chip, and
the first detection signal from the sub line of the first directional coupler is led into the first signal input terminal of the first gain control unit for the first RF power amplifier from the third side of the chip, and the second detection signal from the sub line of the second directional coupler is led into the second signal input terminal of the second gain control unit for the second RF power amplifier from the third side of the chip.

30. The RF module according to claim 29,
wherein a lead-in point of the second detection signal on the third side is disposed between a lead-out point of the first output amplification signal on the first side and a lead-in point of the first detection signal on the third side, and a lead-in point of the first detection signal on the third side is disposed between a lead-out point of the second output amplification signal on the second side and a lead-in point of the second detection signal on the third side.

31. The RF module according to claim 29,
wherein a first ground wiring to be connected to a ground voltage is connected to the third side between a lead-out point of the first output amplification signal on the first side and a lead-in point of the first detection signal on the third side, and a second ground wiring to be connected to the ground voltage is connected to the third side between a lead-out point of the second output amplification signal on the second side and a lead-in point of the second detection signal on the third side.

32. The RF module according to claim 30,
wherein a first ground wiring to be connected to a ground voltage is connected to the third side between the lead-out point of the first output amplification signal on the first side and the lead-in point of the first detection signal on the third side, and a second ground wiring to be connected to the ground voltage is connected to the third side between the lead-out point of the second output amplification signal on the second side and the lead-in point of the second detection signal on the third side.

33. The RF module according to claim 32,
wherein the first ground wiring is disposed adjacent to the third side and between the lead-in point of the second detection signal and the lead-in point of the first detection signal, and the second ground wiring is disposed adjacent to the third side and between the lead-in point of the first detection signal and the lead-in point of the second detection signal.

34. The RF module according to claim 28,
wherein the first frequency band RF signal is an RF transmission signal for GSM850 and GSM900, and the second frequency band RF signal is an RF transmission signal for DCS1800 and PCS1900.

35. The RF module according to claim 28,
wherein each of the first directional coupler and the second directional coupler is constituted of a microcoupler having a capacitive element connected between a main line and a sub line thereof.
